(19) Europäisches Patentamt
European Patent Office
Office européen des brevets

(11) **EP 4 672 648 A1**

(12) **EUROPEAN PATENT APPLICATION**
published in accordance with Art. 153(4) EPC

(43) Date of publication:
**31.12.2025  Bulletin 2026/01**

(21) Application number: **24784204.0**

(22) Date of filing: **30.03.2024**

(51) International Patent Classification (IPC):
**H04L 1/00** (2006.01)

(52) Cooperative Patent Classification (CPC):
**H04L 1/00**

(86) International application number:
**PCT/CN2024/085098**

(87) International publication number:
**WO 2024/208120 (10.10.2024 Gazette 2024/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.04.2023  CN 202310377636**

(71) Applicant: **HUAWEI TECHNOLOGIES CO., LTD.
Shenzhen, Guangdong 518129 (CN)**

(72) Inventors:
• **HE, Xiang
  Shenzhen, Guangdong 518129 (CN)**
• **REN, Hao
  Shenzhen, Guangdong 518129 (CN)**

(74) Representative: **Huawei European IPR
Huawei Technologies Duesseldorf GmbH
Riesstraße 25
80992 München (DE)**

(54) **METHOD AND APPARATUS FOR PROCESSING ETHERNET DATA STREAM, AND COMPUTER SYSTEM AND NETWORK SYSTEM**

(57) A method and an apparatus for processing an Ethernet data stream, a computer system, a network system, and a computer-readable storage medium are disclosed. The method is applied to a receiver apparatus including a first forward error correction FEC decoder and a second FEC decoder. The method includes: obtaining transmission information of a first data stream; and if the transmission information meets a trigger condition, adjusting an error correction capability of the receiver apparatus. The data stream can be flexibly and effectively processed by using the method, the apparatus, the computer system, the network system, and the computer-readable storage medium.

Obtain transmission information of a first data stream — S10

If the transmission information meets a trigger condition, adjust an error correction capability of a receiver apparatus — S20

FIG. 3

**Description**

This application claims priority to Chinese Patent Application No. 202310377636.7, filed with the China National Intellectual Property Administration on April 6, 2023 and entitled "METHOD AND APPARATUS FOR PROCESSING ETHERNET DATA STREAM, COMPUTER SYSTEM, AND NETWORK SYSTEM", which is incorporated herein by reference in its entirety.

**TECHNICAL FIELD**

This application relates to a method and an apparatus for processing an Ethernet data stream, a computer system, a network system, and a computer-readable storage medium.

**BACKGROUND**

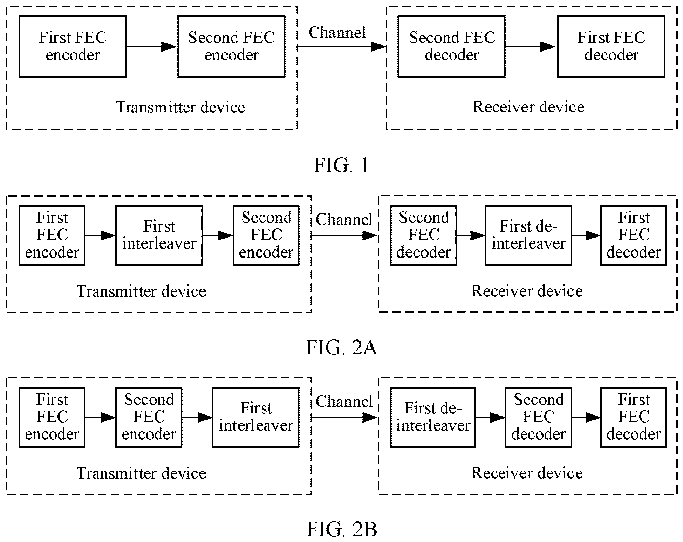

To resist impact of bit errors in communication transmission, forward error correction (forward error correction, FEC) is introduced into communication systems to rectify these bit errors, so as to recover transmitted data. As a communication link rate increases, a bit error ratio (bit error ratio, BER) also rises, necessitating more robust FEC for error correction. In Ethernet communication, the Institute of Electrical and Electronics Engineers (Institute of Electrical and Electronics Engineers, IEEE) 802.3bs standard for 200GE/400GE employs a single-stage FEC RS (544, 514) to address bit errors at the 100G/lane rate. For the 200G/lane rate, to combat ever higher reception BERs, some solutions introduce an additional layer of FEC coding on top of the existing Reed-Solomon (Reed-Solomon, RS) code to form a concatenated code. FIG. 1 is a diagram of basic system transmission utilizing this concatenated code, where a first FEC encoder and a second FEC encoder jointly form the concatenated code. However, in some scenarios, the concatenated code exhibits limited adaptability.

**SUMMARY**

This application discloses a method and an apparatus for processing an Ethernet data stream, a computer system, a network system, and a computer-readable storage medium, to flexibly and effectively process the Ethernet data stream.

According to a first aspect of this application, a method for processing an Ethernet data stream is provided. The method is applied to a receiver apparatus including a first forward error correction FEC decoder and a second FEC decoder. The method includes: obtaining transmission information of a first data stream; and if the transmission information meets a trigger condition, adjusting an error correction capability of the receiver apparatus. According to the method, in a scenario in which a concatenated code is configured, the error correction capability of the receiver apparatus may still be adjusted based on an actual application scenario.

In a possible implementation, the transmission information includes one or more of a bit error ratio BER, a quantity of error bits, a symbol error ratio SER, a quantity of error symbols, a codeword error ratio CER, a quantity of error codewords, channel state information, and an eye pattern parameter of the first data stream. The method in this application may be used as a measurement of a threshold or a trigger condition based on error quantities, error ratios, or the like of various error units, and may be widely used in various scenarios.

In a possible implementation, the receiver apparatus further includes a first de-interleaver, and if the transmission information meets the trigger condition, adjusting the error correction capability of the receiver apparatus includes one or more of (1) to (6):

(1) if a quantity of bit errors in P codewords at the second FEC decoder is less than J, disabling the first de-interleaver and the second FEC decoder, where P and J are positive integers and P>J>1;
(2) if a quantity of bit errors in P codewords at the second FEC decoder is less than K, disabling the first de-interleaver and enabling hard decision decoding HDD of the second FEC decoder, where K is a positive integer and K>J;
(3) if a quantity of bit errors in P codewords at the second FEC decoder is less than L, disabling the first de-interleaver and enabling a configuration 2 of soft decision decoding SDD of the second FEC decoder, where L is a positive integer and L>K;
(4) if a quantity of bit errors in P codewords at the second FEC decoder is less than M, disabling the first de-interleaver and enabling a configuration 1 of SDD of the second FEC decoder, where M>L;
(5) if a quantity of bit errors in P codewords at the second FEC decoder is less than N, enabling a configuration of the FEC decoder as a configuration 1 of SDD and enabling a configuration 2 of the first de-interleaver, where N>M; or
(6) if none of (1) to (5) is met, enabling a configuration 1 of the second FEC decoder and enabling a configuration 1 of the first de-interleaver.

In a possible implementation, if the transmission information meets the trigger condition, adjusting the error correction capability of the receiver apparatus includes any one of the following:

(1) enabling a configuration 1 of soft decision decoding SDD of the second FEC decoder;
(2) enabling a configuration 2 of SDD of the second FEC decoder;
(3) enabling hard decision decoding HDD of the second FEC decoder; or
(4) disabling the second FEC decoder.

An error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder.

In a possible implementation, the receiver apparatus further includes a first de-interleaver, and if the transmission information meets the trigger condition, adjusting the error correction capability of the receiver apparatus includes any one of the following:

(1) enabling a configuration 1 of soft decision decoding SDD of the second FEC decoder and enabling a configuration 1 of the first de-interleaver;
(2) enabling a configuration 1 of SDD of the second FEC decoder and enabling a configuration 2 of the first de-interleaver;
(3) enabling a configuration 1 of SDD of the second FEC decoder and disabling the first de-interleaver;
(4) enabling a configuration 2 of SDD of the second FEC decoder and disabling the first de-interleaver;
(5) enabling hard decision decoding HDD of the second FEC decoder and disabling the first de-interleaver; or
(6) disabling the second FEC decoder and the first de-interleaver.

A de-interleaving delay and/or power consumption of the configuration 1 of the first de-interleaver is higher than a de-interleaving delay and/or power consumption of the configuration 2 of the first de-interleaver, an error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder.

In a possible implementation, the receiver apparatus further includes a data location inverse transformer, a first de-interleaver, and a second de-interleaver, where the data location inverse transformer is configured to perform an inverse transform operation on a location of a received data bit or symbol whose location is transformed by a data location transformer, and if the transmission information meets the trigger condition, adjusting the error correction capability of the receiver apparatus includes any one of the following:

(1) if a bit error ratio BER of a data stream received by the receiver apparatus satisfies BER≤a, disabling the data location inverse transformer, the second FEC decoder, the first de-interleaver, and the second de-interleaver, where a>0;
(2) if a BER of a data stream received by the receiver apparatus satisfies a<BER≤b, disabling the data location inverse transformer, the second de-interleaver, and the first de-interleaver, and enabling hard decision decoding HDD of the second FEC decoder;
(3) if a BER of a data stream received by the receiver apparatus satisfies b<BER≤c, disabling the data location inverse transformer, the second de-interleaver, and the first de-interleaver, and enabling soft decision decoding SDD of the second FEC decoder;
(4) if a BER of a data stream received by the receiver apparatus satisfies c<BER≤d, disabling the data location inverse transformer and the first de-interleaver, and enabling soft decision decoding SDD of the second FEC decoder, the data location inverse transformer, and the second de-interleaver; or
(5) if a BER of a data stream received by the receiver apparatus satisfies d<BER≤e, enabling soft decision decoding SDD of the second FEC decoder, the data location inverse transformer, the second de-interleaver, and the first de-interleaver.

Based on these solutions, the error correction capability of the receiver apparatus may be flexibly adjusted based on strength of the error correction capability and by considering the power consumption, the delay, and/or the like.

In a possible implementation, the transmission information is related to a quantity of error units at the first FEC decoder and/or a quantity of error units at the second FEC decoder.

In a possible implementation, the error unit includes a codeword, a bit, a symbol, or a bit group including any quantity of bits.

In a possible implementation, the transmission information includes information about how to adjust the error correction capability of the receiver apparatus.

In a possible implementation, the information about how to adjust the error correction capability of the receiver apparatus includes: disabling or weakening an error correction capability of the second FEC decoder.

In a possible implementation, the receiver apparatus further includes the de-interleaver, and the information about how to adjust the error correction capability of the receiver apparatus includes:

disabling or weakening an error correction capability of the second FEC decoder; and/or
disabling or weakening a de-interleaving effect of the de-interleaver.

In a possible implementation, the receiver apparatus further includes the de-interleaver and the data location inverse transformer, and the information about how to adjust the error correction capability of the receiver apparatus includes:

disabling or weakening an error correction capability of the second FEC decoder;
disabling or weakening a de-interleaving effect of the de-interleaver; and/or
disabling a function of the data location inverse transformer.

In a possible implementation, the transmission information is from a register of the transmitter/receiver apparatus and/or the transmission information is triggered by a primitive.

According to a second aspect of this application, a method for processing an Ethernet data stream is provided. The method is performed by a transmitter apparatus. The transmitter apparatus includes a first forward error correction FEC encoder and a second FEC encoder. The method includes: configuring a data stream processing manner of the transmitter apparatus based on an indication. According to the method, the data stream processing manner of the transmitter apparatus may be flexibly configured.

In a possible implementation, the indication includes information about how to adjust an error correction capability data stream processing manner of the transmitter apparatus.

In a possible implementation, the indication for configuring the data stream processing manner of the transmitter apparatus includes: disabling or weakening an error correction capability of the second FEC decoder.

In a possible implementation, the transmitter apparatus further includes a first interleaver, and the indication for configuring the data stream processing manner of the transmitter apparatus includes:

disabling or weakening an error correction capability of a second FEC decoder;
and/or

disabling or weakening an interleaving effect of the first interleaver.

In a possible implementation, the transmitter apparatus further includes a first interleaver and a data location transformer, and the indication for configuring the data stream processing manner of the transmitter apparatus includes:

disabling or weakening an error correction capability of a second FEC decoder;
disabling or weakening an error correction capability of the first interleaver; and/or
disabling a function of the data location transformer.

In a possible implementation, the indication is from a receiver apparatus corresponding to the transmitter apparatus.

In a possible implementation, the indication is in a register of the transmitter apparatus and/or the indication is triggered by a primitive.

According to a third aspect of this application, an apparatus for processing an Ethernet physical layer data stream includes a processor. The processor is configured to perform the method according to any one of the first aspect and the possible implementations of the first aspect.

According to a fourth aspect of this application, an apparatus for processing an Ethernet physical layer data stream includes a processor. The processor is configured to perform the method according to any one of the second aspect and the possible implementations of the second aspect.

In a possible implementation, the apparatus includes an Ethernet interface.

According to a fifth aspect of this application, a computer system includes the apparatus.

According to a sixth aspect of this application, a network system includes a transmitter device and a receiver device. The transmitter device includes the apparatus according to any one of the third aspect and possible implementations of the third aspect. The receiver device includes the apparatus according to any one of the fourth aspect and possible implementations of the fourth aspect.

According to a seventh aspect of this application, a computer program (product) is provided. When the computer program is executed by a computer, a processor or the computer may be enabled to perform corresponding steps and/or procedures in the foregoing method embodiments.

A computer-readable storage medium is provided. The computer-readable storage medium stores at least one program instruction or code, and the program instruction or the code is loaded and executed by a computer, to enable the computer to implement any one of the foregoing methods.

A chip is provided, and includes a processor, configured to invoke instructions from a memory and run the instructions stored in the memory, to enable a device in which the chip is installed to perform the methods in the foregoing aspects.

Another chip is provided, and includes an input interface, an output interface, a processor, and a memory. The input interface, the output interface, the processor, and the memory are connected through an internal connection path. The processor is configured to execute code in the memory. When the code is executed, the processor is configured to perform the methods in the foregoing aspects.

A device is provided, and includes the chip in any one of the foregoing solutions.

## BRIEF DESCRIPTION OF DRAWINGS

FIG. 1 is a diagram of a solution of a concatenated code channel transmission model according to this application;
FIG. 2A to FIG. 2N are diagrams of solutions of concatenated code channel transmission models according to this application;
FIG. 3 is a schematic flowchart of a method for processing an Ethernet data stream according to an embodiment of this application;
FIG. 4 is a diagram of a structure of an apparatus for processing an Ethernet data stream according to an embodiment of this application;
FIG. 5 is a diagram of a structure of another apparatus for processing an Ethernet data stream according to an embodiment of this application;
FIG. 6 is a diagram of a structure of a computer system according to an embodiment of this application; and
FIG. 7 is a diagram of a structure of a network system according to an embodiment of this application.

## DESCRIPTION OF EMBODIMENTS

Due to environmental interference, system errors, and the like, bit errors (bit errors, BEs) are unavoidable in communication transmission. Bit errors refer to inconsistency between data obtained by an information receiver and data sent by a transmitter. Bit errors in key control signal transmission of a device may cause system breakdown and data loss. In addition, bit errors greatly affect communication delay and consumer experience in videos, games, calls, and the like. Therefore, a quantity of bit errors, namely, a bit error ratio (bit error ratio, BER) at the information receiver, serves as an important indicator for measuring performance of a communication system.

A smaller BER at the receiver indicates higher transmission reliability. To ensure high reliability of the system, the communication system imposes requirements on a reception BER. For example, the IEEE 802.3bs 400GE standard specifies a BER of data entering a media access control (media access control, MAC) layer of the receiver needs to be lower than $1\times10^{-13}$, namely, $1\times10^{-13}$, while a BER of data immediately after link transmission entering the receiver is about $2.4\times10^{-4}$, namely, $2.4\times10^{-4}$. Therefore, to eliminate most bit errors, FEC is used to correct these bit errors to recover transmitted data. After the FEC correction, the BER of the data entering the MAC layer of the receiver is greatly reduced.

However, changes in environment conditions or human-induced factors affecting a status of a channel may result in a high bit error ratio (namely, a reception BER) of a signal upon arriving at the receiver. Even if the FEC correction is applied, the reception BER may fail to meet a specific communication requirement within a period of time.

As shown in FIG. 1, in a concatenated code channel transmission scenario, a transmitter device includes a first FEC encoder and a second FEC encoder, and a receiver device includes a first FEC decoder and a second FEC decoder. A data stream of the transmitter device is encoded by the first FEC encoder and the second FEC encoder, and then is sent to the receiver device through a PMA/PMD. The receiver device sequentially decodes a received data stream via the second FEC decoder and the second FEC decoder, to obtain the data stream initially sent by the transmitter device. The first FEC encoder is an outer code of a concatenated code, and may be a Reed-Solomon (Reed-Solomon, RS) encoder, for example, encoder of an RS (544, 514) code. Correspondingly, the first FEC decoder may be an RS decoder, for example, decoder of an RS (544, 514) code. The RS (544, 514) code is used for error correction in 10-bit symbols. The second FEC encoder is an inner code of the concatenated code, where the inner code may be an FEC code that is based on bit error correction, and may be different from the RS (544, 514) code. For example, the second FEC encoder may be a Bose-Chaudhuri-Hocquenghem (Bose-Chaudhuri-Hocquenghem, BCH) code encoder, an extended BCH code encoder, a Hamming code encoder, or an extended Hamming code encoder. Correspondingly, the second FEC decoder may be an FEC decoder that is based on bit error correction and that has a same code pattern as the second FEC encoder.

In some embodiments, the first FEC encoder may alternatively be any one of a BCH code encoder, a fire (fire) code encoder, a turbo (turbo) code encoder, a turbo product code (turbo product code, TPC) encoder, a staircase (staircase) code encoder, and a low-density parity-check (low-density parity-check, LDPC) code encoder. The second FEC encoder may alternatively be any one of a fire code encoder, a turbo code encoder, a TPC encoder, a staircase code encoder, and an LDPC code encoder.

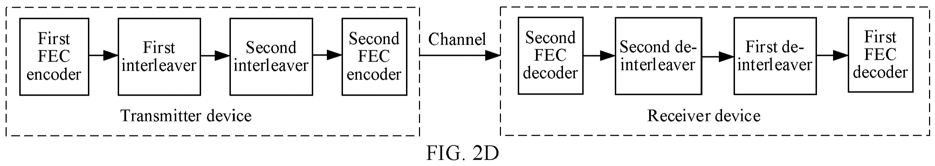

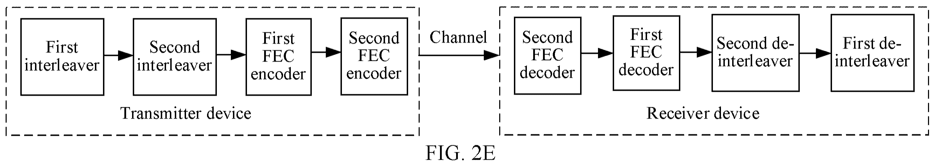

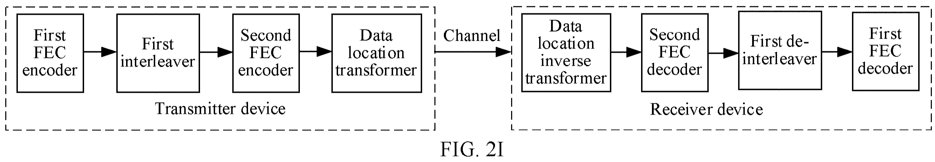

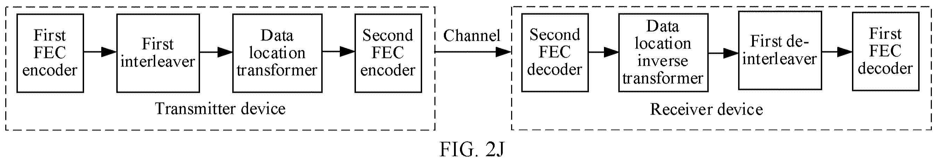

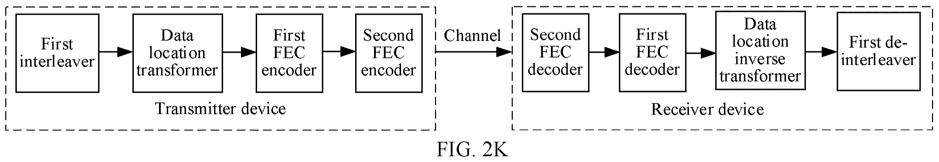

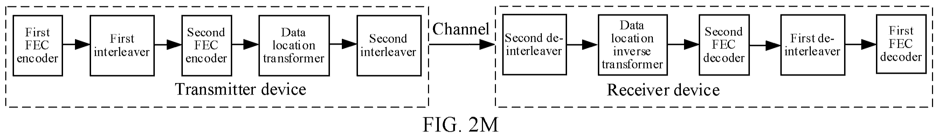

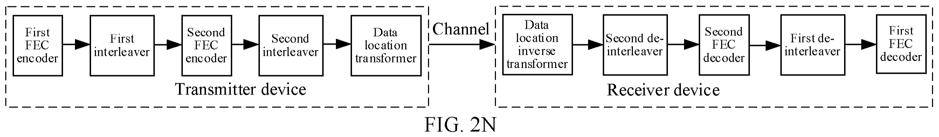

As shown in FIG. 2A and FIG. 2B, in the concatenated code scenario in FIG. 1, a first interleaver is further added between the first FEC encoder and the second FEC encoder, to further reduce a bit error ratio. In some embodiments, the first interleaver may be a convolutional interleaver. Correspondingly, a first de-interleaver is included between the second FEC decoder and the first FEC decoder of the receiver device, and the first de-interleaver may be a convolutional de-interleaver. Based on FIG. 2A, data encoded by the first FEC encoder enters the first interleaver. The first interleaver interleaves the data from the first FEC encoder. Interleaved data enters the second FEC encoder. After the data is encoded by the second FEC encoder, encoded data is sent to the second FEC decoder of the receiver device through a channel. The second FEC decoder corresponds to the second FEC encoder and is configured to decode the data encoded by the second FEC encoder. Data decoded by the second FEC decoder enters the first de-interleaver. The first de-interleaver de-interleaves the entering data. De-interleaved data enters the first FEC decoder. The first FEC decoder performs FEC decoding on the entering data. Based on FIG. 2B, data encoded by the first FEC encoder and the second FEC encoder arrives at the first interleaver. The first interleaver interleaves the data from the first FEC encoder. Interleaved data is sent to the receiver device through the channel. A data stream received by the receiver device is de-interleaved by the first de-interleaver, decoded by the second FEC decoder, and decoded by the first FEC decoder, to obtain original data.

The second FEC decoder may use soft decision decoding (soft decision decoding, SDD). The second FEC decoder used as an inner code uses the soft decision decoding, causing almost all received codewords to be correctable, so that a quantity of error bits can be directly obtained. As a result, statistics on the quantity of bit errors are slightly different from statistics on a quantity of bit errors in an RS code. For an uncorrectable codeword, a quantity of error bits may be set to a minimum Hamming distance d of the inner code. Error statistics of the SDD used by the second FEC decoder used as the inner code may be slightly different from an actual quantity of bit errors, and statistics data may be used to assist in reducing the difference. If hard decision decoding (hard decision decoding, HDD) is used for the inner code, the foregoing error quantity statistics collection manner of the SDD may still be used.

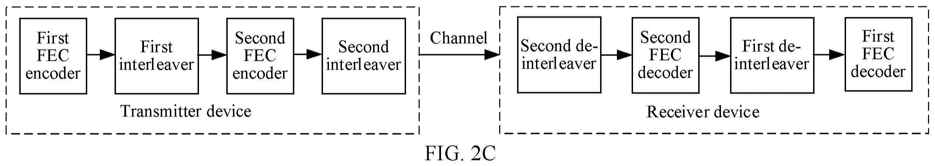

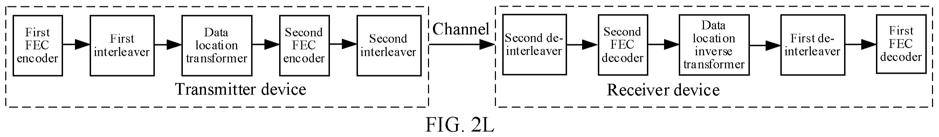

As shown in FIG. 2C to FIG. 2E, based on FIG. 2A and/or FIG. 2B, one or more interleavers may be further added to the transmitter device, to further reduce a bit error ratio through a plurality of times of interleaving. Correspondingly, one or more de-interleavers are further added to the receiver device, to de-interleave a received bitstream obtained through a plurality of times of interleaving. One or more of the one or more further added interleavers may also be convolutional interleavers. Correspondingly, one or more of the one or more de-interleavers further added to the receiver device may also be convolutional de-interleavers. Each of FIG. 2C to FIG. 2E and FIG. 2L to FIG. 2N provides logical structures of a transmitter device and a receiver device in a concatenated code scenario including two interleavers (a first interleaver and a second interleaver shown in any one of FIG. 2C to FIG. 2E and FIG. 2L to FIG. 2N).

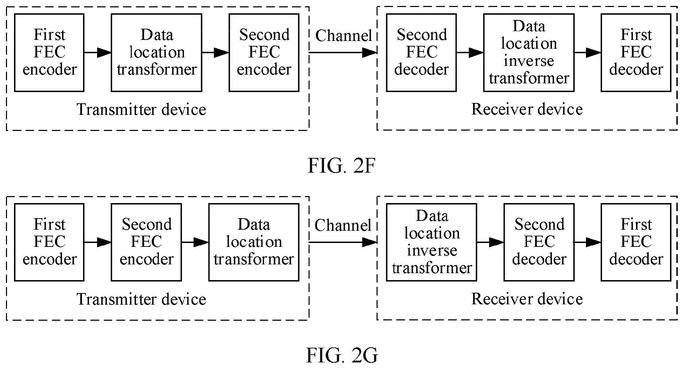

Based on a concatenated code including a plurality of interleavers, a data location transformer may be further added to the transmitter device, and a data location inverse transformer corresponding to the data location transformer may be received in the receiver device, to further reduce a bit error ratio. FIG. 2F and FIG. 2G each show logical structures of a transmitter device and a receiver device in a concatenated code scenario including one interleaver (a first interleaver shown in FIG. 2F and FIG. 2G) and a data location transformer. FIG. 2L to FIG. 2N each show logical structures of a transmitter device and a receiver device in a concatenated code scenario including two interleavers (the first interleaver and the second interleaver shown in FIG. 2L to FIG. 2N) and a data location transformer.

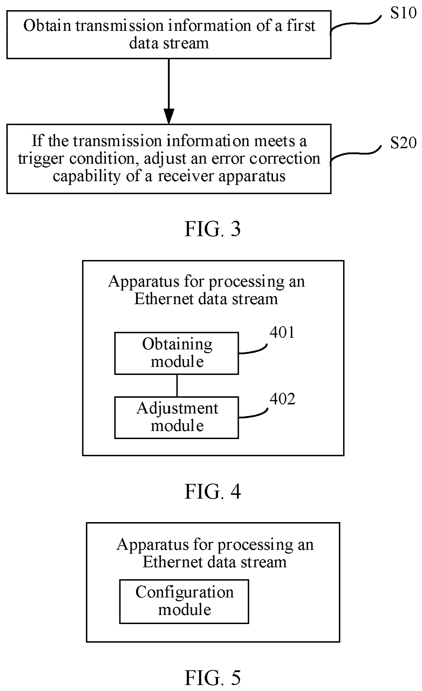

As shown in FIG. 3, an embodiment of this application provides a method for processing an Ethernet data stream. The method is applied to a receiver apparatus including a first FEC decoder and a second FEC decoder. The method includes the following steps.

S10: Obtain transmission information of a first data stream.

Specifically, the first data stream is a data stream sent by a transmitter apparatus to the receiver apparatus, and the receiver apparatus obtains the transmission information of the first data stream based on the first data stream. In some embodiments, the transmission information includes one or more of a bit error ratio BER, a quantity of error bits, a symbol error ratio (symbol error rate, SER), a quantity of error symbols, a codeword error ratio (codeword error rate, CER), a quantity of error codewords, channel state information (channel state information, CSI), and an eye pattern parameter of the first data stream. The channel state information includes a frequency response. The frequency response is a phenomenon that when an electrical signal output at a constant voltage is connected to a system, sound pressure generated by a sound box increases or attenuates and a phase changes with a change of a frequency. An interrelated variation relationship between the sound pressure and the phase and the frequency is referred to as the frequency response. The frequency response is also a frequency range in which the system can replay within an allowable amplitude range, and a variation of the signal within the range is referred to as the frequency response, also referred to as a frequency characteristic. Main parameters of an eye pattern include an extinction ratio, a jitter, a cross point, rising edge time, falling edge time, and a margin. The extinction ratio is defined as a ratio of a "1" level to a "0" level in the eye pattern. Requirements on the extinction ratio vary depending on different rates, transmission distances, and laser types. The extinction ratio is an important parameter for measuring an emission source for optical communication, and a value of the extinction ratio determines quality of a communication signal.

The transmitter apparatus may be the transmitter device shown in any one of FIG. 1 to FIG. 2N, and the receiver apparatus may be the receiver device shown in any one of FIG. 1 to FIG. 2N. The transmitter device includes a first FEC encoder and a second FEC encoder. Correspondingly, the receiver apparatus includes the second FEC decoder and the first FEC decoder. The first FEC encoder of the transmitter device corresponds to the first FEC decoder of the receiver device, and the second FEC encoder of the transmitter device corresponds to the second FEC decoder of the receiver device.

S20: If the transmission information meets a trigger condition, adjust an error correction capability of the receiver apparatus.

The receiver apparatus obtains the transmission information of the first data stream, determines whether the transmission information meets the trigger condition, and adjusts the error correction capability of the receiver apparatus if the transmission information meets the trigger condition. In some embodiments, the receiver apparatus is the receiver device in any one of FIG. 1 to FIG. 2N, and the trigger condition is related to a quantity of error units at the first FEC decoder and/or a quantity of error units at the second FEC decoder. In some embodiments, the error unit includes a codeword, a bit, a symbol, or a bit group including any quantity of bits.

In some embodiments, the receiver apparatus may be the receiver device shown in any one of FIG. 1 to FIG. 2N, the transmission information includes a BER of the first data stream, and adjusting the error correction capability of the receiver apparatus may include any one of the following (1) to (3):

(1) enabling a configuration 1 of SDD of the second FEC decoder;
(2) enabling a configuration 2 of SDD of the second FEC decoder;
(3) enabling HDD of the second FEC decoder; or
(4) disabling the second FEC decoder.

An error correction capability of the configuration 1 of the SDD of the second FEC decoder is higher than an error correction capability of the configuration 2 of the SDD of the second FEC decoder, and the error correction capability of the configuration 2 of the SDD of the second FEC decoder is higher than an error correction capability of the HDD of the second FEC decoder.

In some embodiments, the receiver apparatus may be the receiver device shown in any one of FIG. 1 to FIG. 2N, the transmission information includes the BER of the first data stream, and the trigger condition includes one of the following (a) to (e):

(a) the BER of the first data stream satisfies BER≤a;
(b) the BER of the first data stream satisfies a<BER≤b;
(c) the BER of the first data stream satisfies b<BER≤c;
(d) the BER of the first data stream satisfies c<BER≤d; or
(e) the BER of the first data stream satisfies d<BER≤e, where

$$a > 0.$$

.

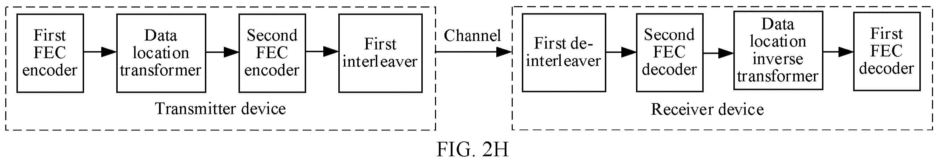

Correspondingly, if the transmission information meets one of the foregoing trigger conditions (a) to (e), the receiver apparatus is the receiver device shown in any one of FIG. 2A to FIG. 2E and FIG. 2H to FIG. 2N, and the receiver apparatus includes the first FEC decoder, the second FEC decoder, and a first de-interleaver, adjusting the error correction capability of the receiver apparatus includes any one of the following (A) to (E):

(A) if the BER of the first data stream satisfies BER≤a, disabling the second FEC decoder and the first de-interleaver, where a>0;

(B) if the BER of the first data stream satisfies a<BER≤b, disabling the first de-interleaver and enabling the HDD of the second FEC decoder;

(C) if the BER of the first data stream satisfies b<BER≤c, disabling the first de-interleaver and enabling the configuration 2 of the SDD of the second FEC decoder;

(D) if the BER of the first data stream satisfies c<BER≤d, disabling the first de-interleaver and enabling the configuration 1 of the SDD of the second FEC decoder; or

(E) if the BER of the first data stream satisfies d<BER≤e, enabling the configuration 1 of the SDD of the second FEC decoder and the first de-interleaver.

Correspondingly, if the transmission information meets one of the foregoing trigger conditions (a) to (e), the receiver apparatus is the receiver device shown in any one of FIG. 2C to FIG. 2E, and the receiver apparatus includes the first FEC decoder, the second FEC decoder, a first de-interleaver, and a second de-interleaver, adjusting the error correction capability of the receiver apparatus includes any one of the following (A) to (E):

(A) if the BER of the first data stream satisfies BER≤a, disabling the second FEC decoder, the first de-interleaver, and the second de-interleaver, where a>0;

(B) if the BER of the first data stream satisfies a<BER≤b, disabling the first de-interleaver and the second de-interleaver, and enabling the HDD of the second FEC decoder;

(C) if the BER of the first data stream satisfies b<BER≤c, disabling the first de-interleaver and the second de-interleaver, and enabling the SDD of the second FEC decoder;

(D) if the BER of the first data stream satisfies c<BER≤d, disabling the first de-interleaver and the second de-interleaver, and enabling the SDD of the second FEC decoder; or

(E) if the BER of the first data stream satisfies d<BER≤e, enabling the SDD of the second FEC decoder and the first de-interleaver.

Correspondingly, if the transmission information meets one of the foregoing trigger conditions (a) to (e), the receiver apparatus is the receiver device shown in FIG. 2F and FIG. 2G, and the receiver apparatus includes the first FEC decoder, the second FEC decoder, and a data location inverse transformer, adjusting the error correction capability of the receiver apparatus includes any one of the following (A) to (E):

(A) if the BER of the first data stream satisfies BER≤a, disabling the second FEC decoder and the data location inverse transformer;

(B) if the BER of the first data stream satisfies a<BER≤b, disabling the second FEC decoder and enabling the data location inverse transformer;

(C) if the BER of the first data stream satisfies b<BER≤c, disabling the data location inverse transformer and enabling the HDD of the second FEC decoder;

(D) if the BER of the first data stream satisfies c<BER≤d, disabling the data location inverse transformer and enabling the SDD of the second FEC decoder; or

(E) if the BER of the first data stream satisfies d<BER≤e, enabling the SDD of the second FEC decoder and the data location inverse transformer.

Correspondingly, if the transmission information meets one of the foregoing trigger conditions (a) to (e), the receiver apparatus is the receiver device shown in any one of FIG. 2H to FIG. 2N, and the receiver apparatus includes the first FEC decoder, the second FEC decoder, a data location inverse transformer, and a first de-interleaver, where the data location inverse transformer is configured to perform an inverse transform operation on a location of a received data bit or symbol whose location is transformed by a data location transformer, adjusting the error correction capability of the receiver apparatus includes any one of the following (A) to (E):

(A) if the BER of the first data stream satisfies BER≤a, disabling the data location inverse transformer, the second FEC decoder, and the first de-interleaver, where a>0;

(B) if the BER of the first data stream satisfies a<BER≤b, disabling the data location inverse transformer and the first de-interleaver, and enabling the HDD of the second FEC decoder;

(C) if the BER of the first data stream satisfies b<BER≤c, disabling the first de-interleaver and enabling the SDD of the second FEC decoder;

(D) if the BER of the first data stream satisfies c<BER≤d, disabling the data location inverse transformer and enabling the first de-interleaver and the SDD of the second FEC decoder; or

(E) if the BER of the first data stream satisfies d<BER≤e, enabling the SDD of the second FEC decoder, the data location inverse transformer, and the first de-interleaver.

Correspondingly, if the transmission information meets one of the foregoing trigger conditions (a) to (e), the receiver apparatus is the receiver device shown in any one of FIG. 2L to FIG. 2N, and the receiver apparatus includes the first FEC decoder, the second FEC decoder, a data location inverse transformer, a first de-interleaver, and a second de-interleaver, where the data location inverse transformer is configured to perform an inverse transform operation on a location of a received data bit or symbol whose location is transformed by a data location transformer, adjusting the error correction capability of the receiver apparatus includes any one of the following (A) to (E):

(A) if the BER of the first data stream satisfies BER≤a, disabling the data location inverse transformer, the second FEC decoder, the first de-interleaver, and the second de-interleaver, where a>0;
(B) if the BER of the first data stream satisfies a<BER≤b, disabling the data location inverse transformer, the second de-interleaver, and the first de-interleaver, and enabling the HDD of the second FEC decoder;
(C) if the BER of the first data stream satisfies b<BER≤c, disabling the data location inverse transformer, the second de-interleaver, and the first de-interleaver, and enabling the SDD of the second FEC decoder;
(D) if the BER of the first data stream satisfies c<BER≤d, disabling the first de-interleaver and enabling the SDD of the second FEC decoder; or
(E) if the BER of the first data stream satisfies d<BER≤e, enabling the SDD of the second FEC decoder and the first de-interleaver.

In some embodiments, the receiver apparatus may be the receiver device shown in any one of FIG. 1 to FIG. 2N, the transmission information includes a quantity of codeword errors of the first data stream, and adjusting the error correction capability of the receiver apparatus includes one of the following (a) to (e):

(I) disabling the second FEC decoder;
(II) enabling HDD of the second FEC decoder;
(III) enabling a configuration 2 of SDD of the second FEC decoder;
(IV) enabling a configuration 1 of SDD of the second FEC decoder;
(V) enabling a configuration of the FEC decoder as a configuration 1 of SDD and enabling a configuration 2 of a first de-interleaver; or
(VI) enabling a configuration 1 of the second FEC decoder and enabling a configuration 1 of a first de-interleaver.

Correspondingly, if the transmission information meets one of the foregoing trigger conditions (I) to (IV), the receiver apparatus may be the receiver device shown in any one of FIG. 1 to FIG. 2N, the receiver apparatus includes the first FEC decoder and the second FEC decoder, and the transmission information includes one of the following (I) to (VI):

(I) a quantity of bit errors in P codewords at the second FEC decoder is less than J, where P and J are positive integers and P>J>1;
(II) a quantity of bit errors in P codewords at the second FEC decoder is less than K, where K is a positive integer and K>J;
(III) a quantity of bit errors in P codewords at the second FEC decoder is less than L, where L is a positive integer and L>K;
(IV) a quantity of bit errors in P codewords at the second FEC decoder is less than M, where M>L;
(V) a quantity of bit errors in P codewords at the second FEC decoder is less than N, where N>M; or
(VI) none of (I) to (V) is met.

Correspondingly, if the transmission information meets one of the foregoing trigger conditions (I) to (VI), the receiver apparatus may be the receiver device shown in any one of FIG. 1 to FIG. 2N, and the receiver apparatus includes the first FEC decoder and the second FEC decoder, adjusting the error correction capability of the receiver apparatus includes any one of the following:

(I) if the quantity of bit errors in the P codewords at the second FEC decoder is less than J, where P and J are the positive integers and P>J>1, disabling the second FEC decoder;
(II) if the quantity of bit errors in the P codewords at the second FEC decoder is less than K, where K is the positive integer and K>J, enabling the HDD of the second FEC decoder;
(III) if the quantity of bit errors in the P codewords at the second FEC decoder is less than L, where L is the positive integer and L>K, enabling the configuration 2 of the SDD of the second FEC decoder; or
(IV) if the quantity of bit errors in the P codewords at the second FEC decoder is less than M, where M>L, enabling the configuration 1 of the SDD of the second FEC decoder.

An error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder.

Correspondingly, if the transmission information meets one of the foregoing trigger conditions (I) to (VI), in some embodiments, the receiver apparatus may be the receiver device shown in any one of FIG. 2A to FIG. 2E and FIG. 2H to FIG. 2N, and the receiver apparatus includes the first FEC decoder, the second FEC decoder, and a first de-interleaver, adjusting the error correction capability of the receiver apparatus includes one of (I) to (VI):

(I) if the quantity of bit errors in the P codewords at the second FEC decoder is less than J, disabling the first de-interleaver and the second FEC decoder, where P and J are the positive integers and P>J>1;

(II) if the quantity of bit errors in the P codewords at the second FEC decoder is less than K, disabling the first de-interleaver and enabling the HDD of the second FEC decoder, where K is the positive integer and K>J;

(III) if the quantity of bit errors in the P codewords at the second FEC decoder is less than L, disabling the first de-interleaver and enabling the configuration 2 of the SDD of the second FEC decoder, where L is the positive integer and L>K;

(IV) if the quantity of bit errors in the P codewords at the second FEC decoder is less than M, disabling the first de-interleaver and enabling the configuration 1 of the SDD of the second FEC decoder, where M>L;

(V) if the quantity of bit errors in the P codewords at the second FEC decoder is less than N, enabling the configuration of the FEC decoder as the configuration 1 of the SDD and enabling the configuration 2 of the first de-interleaver, where N>M; or

(VI) if none of (1) to (5) is met, enabling the configuration 1 of the second FEC decoder and enabling the configuration 1 of the first de-interleaver.

Correspondingly, if the transmission information meets one of the trigger conditions (I) to (VI), in some embodiments, the receiver apparatus may be the receiver device shown in either of FIG. 2F and FIG. 2G, and the receiver apparatus includes the first FEC decoder, the second FEC decoder, and a data location inverse transformer, adjusting the error correction capability of the receiver apparatus includes one of (I) to (VI):

(I) if the quantity of bit errors in the P codewords at the second FEC decoder is less than J, disabling the data location inverse transformer and the second FEC decoder, where P and J are the positive integers and P>J>1;

(II) if the quantity of bit errors in the P codewords at the second FEC decoder is less than K, disabling the second FEC decoder and enabling the data location inverse transformer, where K is the positive integer and K>J;

(III) if the quantity of bit errors in the P codewords at the second FEC decoder is less than L, disabling the data location inverse transformer and enabling the HDD of the second FEC decoder, where L is the positive integer and L>K;

(IV) if the quantity of bit errors in the P codewords at the second FEC decoder is less than M, disabling the data location inverse transformer and enabling the configuration 2 of the SDD of the second FEC decoder, where M>L;

(V) if the quantity of bit errors in the P codewords at the second FEC decoder is less than N, disabling the data location inverse transformer and enabling the configuration of the FEC decoder as the configuration 1 of the SDD, where N>M; or

(VI) if none of (I) to (V) is met, enabling the configuration 1 of the SDD of the second FEC decoder and enabling the data location inverse transformer.

Correspondingly, if the transmission information meets one of the foregoing trigger conditions (I) to (VI), in some embodiments, the receiver apparatus may be the receiver device shown in any one of FIG. 2C to FIG. 2E and FIG. 2L to FIG. 2N, and the receiver apparatus includes the first FEC decoder, the second FEC decoder, a first de-interleaver, and a second de-interleaver, adjusting the error correction capability of the receiver apparatus includes one of (I) to (VI):

(I) if the quantity of bit errors in the P codewords at the second FEC decoder is less than J, disabling the first de-interleaver, the second de-interleaver, and the second FEC decoder, where P and J are the positive integers and P>J>1;

(II) if the quantity of bit errors in the P codewords at the second FEC decoder is less than K, disabling the second de-interleaver and the second FEC decoder, and enabling the first de-interleaver, where K is the positive integer and K>J;

(III) if the quantity of bit errors in the P codewords at the second FEC decoder is less than L, disabling the second FEC decoder and enabling the first de-interleaver and the second de-interleaver, where L is the positive integer and L>K;

(IV) if the quantity of bit errors in the P codewords at the second FEC decoder is less than M, disabling the first de-interleaver and the second de-interleaver, and enabling the HDD of the second FEC decoder, where M>L;

(V) if the quantity of bit errors in the P codewords at the second FEC decoder is less than N, disabling the first de-interleaver and the second de-interleaver, and enabling the configuration 2 of the SDD of the second FEC decoder, where N>M; or

(VI) if none of (1) to (5) is met, disabling the first de-interleaver and the second de-interleaver, and enabling the configuration 1 of the SDD of the second FEC decoder.

Correspondingly, if the transmission information meets one of the foregoing trigger conditions (I) to (VI), in some embodiments, the receiver apparatus may be the receiver device shown in any one of FIG. 2L to FIG. 2N, and the receiver apparatus includes the first FEC decoder, the second FEC decoder, a first de-interleaver, a second de-interleaver, and a data location inverse transformer, adjusting the error correction capability of the receiver apparatus includes one of (I) to (VI):

(I) if the quantity of bit errors in the P codewords at the second FEC decoder is less than J, disabling the first de-interleaver, the second de-interleaver, the second FEC decoder, and the data location inverse transformer, where P and J are the positive integers and P>J>1;

(II) if the quantity of bit errors in the P codewords at the second FEC decoder is less than K, disabling the second de-interleaver, the second FEC decoder, and the data location inverse transformer, and enabling the first de-interleaver, where K is the positive integer and K>J;

(III) if the quantity of bit errors in the P codewords at the second FEC decoder is less than L, disabling the second FEC decoder and enabling the first de-interleaver, the second de-interleaver, and the data location inverse transformer, where L is the positive integer and L>K;

(IV) if the quantity of bit errors in the P codewords at the second FEC decoder is less than M, disabling the first de-interleaver, the data location inverse transformer, and the second de-interleaver, and enabling the HDD of the second FEC decoder, where M>L;

(V) if the quantity of bit errors in the P codewords at the second FEC decoder is less than N, disabling the first de-interleaver and the second de-interleaver, and enabling the configuration 2 of the SDD of the second FEC decoder, where N>M; or

(VI) if none of (1) to (5) is met, disabling the first de-interleaver and the second de-interleaver, and enabling the configuration 1 of the SDD of the second FEC decoder.

A de-interleaving delay and/or power consumption of the configuration 1 of the first de-interleaver is higher than a de-interleaving delay and/or power consumption of the configuration 2 of the first de-interleaver, an error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder. Error correction capabilities of the first de-interleaver and the second FEC decoder are higher than a function of the data location inverse transformer.

In some embodiments, the receiver apparatus may be the receiver device shown in any one of FIG. 1 to FIG. 2N, and the transmission information includes a quantity of error units of the first data stream. In some embodiments, the transmission information includes one or more of the bit error ratio BER, the quantity of error bits, the symbol error ratio SER, the quantity of error symbols, the codeword error ratio CER, the quantity of error codewords, the channel state information, and the eye pattern parameter of the first data stream. For example, the error unit is the error codeword. The trigger condition includes the following. The receiver apparatus may be the receiver device shown in any one of FIG. 2A to FIG. 2E and FIG. 2H to FIG. 2N. The receiver apparatus further includes a first de-interleaver. Adjusting the error correction capability of the receiver apparatus includes any one of the following:

① enabling a configuration 1 of soft decision decoding SDD of the second FEC decoder and enabling a configuration 1 of the first de-interleaver;

② enabling a configuration 1 of SDD of the second FEC decoder and enabling a configuration 2 of the first de-interleaver;

③ enabling a configuration 1 of SDD of the second FEC decoder and disabling the first de-interleaver;

④ enabling a configuration 2 of SDD of the second FEC decoder and disabling the first de-interleaver;

⑤ enabling hard decision decoding HDD of the second FEC decoder and disabling the first de-interleaver; or

⑥ disabling the second FEC decoder and the first de-interleaver.

A de-interleaving delay and/or power consumption of the configuration 1 of the first de-interleaver is higher than a de-interleaving delay and/or power consumption of the configuration 2 of the first de-interleaver, an error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder. Error correction capabilities of the first de-interleaver and the second FEC decoder are higher than a function of a data location inverse transformer.

Correspondingly, if the transmission information meets one of the foregoing trigger conditions ① to ⑥, in some embodiments, the receiver apparatus may be the receiver device shown in any one of FIG. 2A to FIG. 2E and FIG. 2H to FIG. 2N, and the receiver apparatus includes the first FEC decoder, the second FEC decoder, and the first de-interleaver, adjusting the error correction capability of the receiver apparatus includes one of ① to ⑥:

① if a quantity of bit errors in P codewords at the second FEC decoder is less than J, enabling the configuration 1 of the soft decision decoding SDD of the second FEC decoder and enabling the configuration 1 of the first de-interleaver, where P and J are positive integers and P>J>1;

② if a quantity of bit errors in P codewords at the second FEC decoder is less than K, enabling the configuration 1 of the SDD of the second FEC decoder and enabling the configuration 2 of the first de-interleaver, where K is a positive integer and K>J;

③ if a quantity of bit errors in P codewords at the second FEC decoder is less than L, enabling the configuration 1 of the SDD of the second FEC decoder and disabling the first de-interleaver, where L is a positive integer and L>K;

④ if a quantity of bit errors in P codewords at the second FEC decoder is less than M, enabling the configuration 2 of the SDD of the second FEC decoder and disabling the first de-interleaver, where M>L;

⑤ if a quantity of bit errors in P codewords at the second FEC decoder is less than N, enabling the hard decision decoding HDD of the second FEC decoder and disabling the first de-interleaver, where N>M; or

⑥ if none of ① to ⑤ is met, disabling the second FEC decoder and the first de-interleaver.

Specifically, for an example in which a threshold of a reception BER is used as a trigger condition to trigger adjustment of the error correction capability of the receiver apparatus, refer to Table 1.

Table 1

| Threshold of the BER of the first data stream | Disable convolutional interleaving? | Disable FEC 2? | Enable an FEC 2 decoding scheme? |
|---|---|---|---|
| $4.6 \times 10^{-3}$ | No | No | Soft decoding |
| $3.3 \times 10^{-3}$ | Yes | No | Soft decoding |
| $6.1 \times 10^{-4}$ | Yes | No | Hard decoding |
| $2.4 \times 10^{-4}$ | Yes | Yes | No |

In some embodiments, the receiver apparatus may be the receiver device shown in any one of FIG. 1 to FIG. 2N. When receiving a manually triggered first indication, if the first indication does not include information about how to perform adjustment, the receiver apparatus adjusts the error correction capability of the receiver apparatus in a first preset manner. In some embodiments, the first indication may be in a register of the receiver apparatus and/or the first indication is triggered by a primitive (primitive). In some embodiments, the first preset manner may include any one of the following (1) to (3):

(1) enabling a configuration 1 of SDD of the second FEC decoder;
(2) enabling a configuration 2 of SDD of the second FEC decoder;
(3) enabling HDD of the second FEC decoder; or
(4) disabling the second FEC decoder.

An error correction capability of the configuration 1 of the SDD of the second FEC decoder is higher than an error correction capability of the configuration 2 of the SDD of the second FEC decoder, and the error correction capability of the configuration 2 of the SDD of the second FEC decoder is higher than an error correction capability of the HDD of the second FEC decoder.

In some embodiments, the receiver apparatus is the receiver device shown in any one of FIG. 2A to FIG. 2E and FIG. 2H to FIG. 2N, the receiver apparatus includes the first FEC decoder, the second FEC decoder, and a first de-interleaver, and the first preset manner includes any one of the following (A) to (E):

(A) disabling the second FEC decoder and the first de-interleaver;
(B) disabling the first de-interleaver and enabling HDD of the second FEC decoder;
(C) disabling the first de-interleaver and enabling a configuration 2 of SDD of the second FEC decoder;
(D) disabling the first de-interleaver and enabling a configuration 1 of SDD of the second FEC decoder; or
(E) enabling a configuration 1 of SDD of the second FEC decoder and the first de-interleaver.

In some embodiments, the receiver apparatus is the receiver device shown in any one of FIG. 2C to FIG. 2E, the receiver apparatus includes the first FEC decoder, the second FEC decoder, a first de-interleaver, and a second de-interleaver, and the first preset manner includes any one of the following (A) to (E):

(A) disabling the second FEC decoder, the first de-interleaver, and the second de-interleaver;
(B) disabling the first de-interleaver and the second de-interleaver, and enabling HDD of the second FEC decoder;
(C) disabling the first de-interleaver and the second de-interleaver, and enabling SDD of the second FEC decoder;
(D) disabling the first de-interleaver and the second de-interleaver, and enabling SDD of the second FEC decoder; or
(E) enabling SDD of the second FEC decoder and the first de-interleaver.

In some embodiments, the receiver apparatus is the receiver device shown in FIG. 2F and FIG. 2G, the receiver apparatus includes the first FEC decoder, the second FEC decoder, and a data location inverse transformer, and the first preset manner includes any one of the following (A) to (E):

(A) disabling the second FEC decoder and the data location inverse transformer;
(B) disabling the second FEC decoder and enabling the data location inverse transformer;
(C) disabling the data location inverse transformer and enabling HDD of the second FEC decoder;
(D) disabling the data location inverse transformer and enabling SDD of the second FEC decoder; or
(E) enabling SDD of the second FEC decoder and the data location inverse transformer.

In some embodiments, the receiver apparatus is the receiver device shown in any one of FIG. 2H to FIG. 2N, and the receiver apparatus includes the first FEC decoder, the second FEC decoder, a data location inverse transformer, and a first de-interleaver, where the data location inverse transformer is configured to perform an inverse transform operation on a location of a received data bit or symbol whose location is transformed by a data location transformer. In this case, the first preset manner includes any one of the following (A) to (E):

(A) disabling the data location inverse transformer, the second FEC decoder, and the first de-interleaver;
(B) disabling the data location inverse transformer and the first de-interleaver, and enabling HDD of the second FEC decoder;
(C) disabling the first de-interleaver and enabling SDD of the second FEC decoder;
(D) disabling the data location inverse transformer and enabling the first de-interleaver and SDD of the second FEC decoder; or
(E) enabling SDD of the second FEC decoder, the data location inverse transformer, and the first de-interleaver.

In some embodiments, the receiver apparatus is the receiver device shown in any one of FIG. 2L to FIG. 2N, and the receiver apparatus includes the first FEC decoder, the second FEC decoder, a data location inverse transformer, a first de-interleaver, and a second de-interleaver, where the data location inverse transformer is configured to perform an inverse transform operation on a location of a received data bit or symbol whose location is transformed by a data location transformer. The first indication includes any one of the following (A) to (E):

(A) disabling the data location inverse transformer, the second FEC decoder, the first de-interleaver, and the second de-interleaver;
(B) disabling the data location inverse transformer, the second de-interleaver, and the first de-interleaver, and enabling HDD of the second FEC decoder;
(C) disabling the data location inverse transformer, the second de-interleaver, and the first de-interleaver, and enabling SDD of the second FEC decoder;
(D) disabling the first de-interleaver and enabling SDD of the second FEC decoder; or
(E) enabling SDD of the second FEC decoder and the first de-interleaver.

In some embodiments, the first indication includes information about how to adjust the error correction capability of the receiver apparatus. The first indication may include any one of the foregoing (1) to (3). In this way, the receiver apparatus may adjust the error correction capability of the receiver apparatus based on content included in the first indication.

In some embodiments, the receiver apparatus is the receiver device shown in any one of FIG. 2A to FIG. 2E and FIG. 2H to FIG. 2N, the receiver apparatus includes the first FEC decoder, the second FEC decoder, and a first de-interleaver, and the first indication includes any one of the following (A) to (E):

(A) if a BER of the first data stream satisfies BER≤a, disabling the second FEC decoder and the first de-interleaver, where a>0;

(B) if a BER of the first data stream satisfies a<BER≤b, disabling the first de-interleaver and enabling HDD of the second FEC decoder;

(C) if a BER of the first data stream satisfies b<BER≤c, disabling the first de-interleaver and enabling a configuration 2 of SDD of the second FEC decoder;

(D) if a BER of the first data stream satisfies c<BER≤d, disabling the first de-interleaver and enabling a configuration 1 of SDD of the second FEC decoder; or

(E) if a BER of the first data stream satisfies d<BER≤e, enabling a configuration 1 of SDD of the second FEC decoder and the first de-interleaver.

In some embodiments, the receiver apparatus is the receiver device shown in any one of FIG. 2C to FIG. 2E and FIG. 2L to FIG. 2N, the receiver apparatus includes the first FEC decoder, the second FEC decoder, a first de-interleaver, and a second de-interleaver, and the first indication includes any one of the following (A) to (E):

(A) if a BER of the first data stream satisfies BER≤a, disabling the second FEC decoder, the first de-interleaver, and the second de-interleaver, where a>0;

(B) if a BER of the first data stream satisfies a<BER≤b, disabling the first de-interleaver and the second de-interleaver, and enabling HDD of the second FEC decoder;

(C) if a BER of the first data stream satisfies b<BER≤c, disabling the first de-interleaver and the second de-interleaver, and enabling SDD of the second FEC decoder;

(D) if a BER of the first data stream satisfies c<BER≤d, disabling the first de-interleaver and the second de-interleaver, and enabling SDD of the second FEC decoder; or

(E) if a BER of the first data stream satisfies d<BER≤e, enabling SDD of the second FEC decoder and the first de-interleaver.

In some embodiments, the receiver apparatus is the receiver device shown in FIG. 2F and FIG. 2G, the receiver apparatus includes the first FEC decoder, the second FEC decoder, and a data location inverse transformer, and the first indication includes any one of the following (A) to (E):

(A) if a BER of the first data stream satisfies BER≤a, disabling the second FEC decoder and the data location inverse transformer, where a>0;

(B) if a BER of the first data stream satisfies a<BER≤b, disabling the second FEC decoder and enabling the data location inverse transformer;

(C) if a BER of the first data stream satisfies b<BER≤c, disabling the data location inverse transformer and enabling HDD of the second FEC decoder;

(D) if a BER of the first data stream satisfies c<BER≤d, disabling the data location inverse transformer and enabling SDD of the second FEC decoder; or

(E) if a BER of the first data stream satisfies d<BER≤e, enabling SDD of the second FEC decoder and the data location inverse transformer.

In some embodiments, the receiver apparatus is the receiver device shown in any one of FIG. 2H to FIG. 2N, and the receiver apparatus includes the first FEC decoder, the second FEC decoder, a data location inverse transformer, and a first de-interleaver, where the data location inverse transformer is configured to perform an inverse transform operation on a location of a received data bit or symbol whose location is transformed by a data location transformer. In this case, the first indication includes any one of the following (A) to (E):

(A) if a BER of the first data stream satisfies BER≤a, disabling the data location inverse transformer, the second FEC decoder, and the first de-interleaver, where a>0;

(B) if a BER of the first data stream satisfies a<BER≤b, disabling the data location inverse transformer and the first de-interleaver, and enabling HDD of the second FEC decoder;

(C) if a BER of the first data stream satisfies b<BER≤c, disabling the first de-interleaver and enabling SDD of the second FEC decoder;

(D) if a BER of the first data stream satisfies c<BER≤d, disabling the data location inverse transformer and enabling the first de-interleaver and SDD of the second FEC decoder; or

(E) if a BER of the first data stream satisfies d<BER≤e, enabling SDD of the second FEC decoder, the data location inverse transformer, and the first de-interleaver.

In some embodiments, the receiver apparatus is the receiver device shown in any one of FIG. 2L to FIG. 2N, and the receiver apparatus further includes a data location inverse transformer, a first de-interleaver, and a second de-interleaver, where the data location inverse transformer is configured to perform an inverse transform operation on a location of a received data bit or symbol whose location is transformed by a data location transformer. The first indication includes any one of the following (A) to (E):

(A) if a BER of the first data stream satisfies BER≤a, disabling the data location inverse transformer, the second FEC decoder, the first de-interleaver, and the second de-interleaver, where a>0;
(B) if a BER of the first data stream satisfies a<BER≤b, disabling the data location inverse transformer, the second de-interleaver, and the first de-interleaver, and enabling HDD of the second FEC decoder;
(C) if a BER of the first data stream satisfies b<BER≤c, disabling the data location inverse transformer, the second de-interleaver, and the first de-interleaver, and enabling SDD of the second FEC decoder;
(D) if a BER of the first data stream satisfies c<BER≤d, disabling the first de-interleaver and enabling SDD of the second FEC decoder; or
(E) if a BER of the first data stream satisfies d<BER≤e, enabling SDD of the second FEC decoder and the first de-interleaver.

An embodiment of this application further provides another method for processing an Ethernet physical layer data stream. The method is performed by a transmitter apparatus. The transmitter apparatus may be the transmitter device in any one of FIG. 1 to FIG. 2N. The method includes: configuring a data stream processing manner of the transmitter apparatus based on a second indication.

In some embodiments, the second indication includes information about how to configure the data stream processing manner of the transmitter apparatus.

In some embodiments, the second indication is in a register of the transmitter apparatus and/or the second indication is triggered by a primitive.

In some embodiments, the second indication is from a receiver apparatus corresponding to the transmitter apparatus.

In some embodiments, the transmitter apparatus may be the transmitter device shown in any one of FIG. 1 to FIG. 2N, the transmitter apparatus includes a first FEC encoder and a second FEC encoder, and the second indication may include any one of the following (1) to (3):

(1) enabling a configuration 1 of SDD of the second FEC encoder;
(2) enabling a configuration 2 of SDD of the second FEC encoder;
(3) enabling HDD of the second FEC encoder; or
(4) disabling the second FEC decoder.

An error correction capability of the configuration 1 of the SDD of the second FEC encoder is higher than an error correction capability of the configuration 2 of the SDD of the second FEC encoder, and the error correction capability of the configuration 2 is higher than an error correction capability of the HDD of the second FEC encoder.

In some embodiments, the transmitter apparatus may be the transmitter device shown in any one of FIG. 2A to FIG. 2E and FIG. 2H to FIG. 2N, the transmitter apparatus includes a first FEC encoder, a second FEC encoder, and a first interleaver, and the second indication may include any one of the following ① to ⑥:

① enabling a configuration 1 of SDD of the second FEC encoder and enabling a configuration 1 of the first interleaver;
② enabling a configuration 1 of SDD of the second FEC encoder and enabling a configuration 2 of the first interleaver;
③ enabling a configuration 1 of SDD of the second FEC encoder and disabling the first interleaver;
④ enabling a configuration 2 of SDD of the second FEC encoder and disabling the first interleaver;
⑤ enabling HDD of the second FEC encoder and disabling the first interleaver; or
⑥ disabling the second FEC encoder and the first interleaver.

In some embodiments, the transmitter apparatus is the transmitter device shown in any one of FIG. 2A to FIG. 2E and FIG. 2H to FIG. 2N, the receiver apparatus includes a first FEC encoder, a second FEC encoder, and a first interleaver, and the second indication includes any one of the following (A) to (E):

(A) disabling the second FEC encoder and the first interleaver;
(B) disabling the first interleaver and enabling HDD of the second FEC encoder;
(C) disabling the first interleaver and enabling a configuration 2 of SDD of the second FEC encoder;
(D) disabling the first interleaver and enabling a configuration 1 of SDD of the second FEC encoder; or
(E) enabling a configuration 1 of SDD of the second FEC encoder and the first interleaver.

In some embodiments, the transmitter apparatus is the transmitter device shown in any one of FIG. 2C to FIG. 2E and FIG. 2L to FIG. 2N, the transmitter apparatus includes a first FEC encoder, a second FEC encoder, a first interleaver, and a second interleaver, and the second preset manner includes any one of the following (A) to (E):

(A) disabling the second FEC encoder, the first interleaver, and the second interleaver;
(B) disabling the first interleaver and the second interleaver, and enabling HDD of the second FEC encoder;
(C) disabling the first interleaver and the second interleaver, and enabling SDD of the second FEC encoder;
(D) disabling the first interleaver and the second interleaver, and enabling SDD of the second FEC encoder; or
(E) enabling SDD of the second FEC encoder and the first interleaver.

An interleaving delay and/or power consumption of a configuration 1 of the first interleaver is higher than an interleaving delay and/or power consumption of a configuration 2 of the first interleaver, an error correction capability a configuration 1 of the SDD of the second FEC encoder is higher than an error correction capability of a configuration 2 of the SDD of the second FEC encoder, and the error correction capability of the configuration 2 is higher than an error correction capability of the HDD of the second FEC encoder.

In some embodiments, the transmitter apparatus may be the transmitter device shown in either of FIG. 2F and FIG. 2G, the transmitter apparatus includes a first FEC encoder, a second FEC encoder, and a data location transformer, and the second indication includes one of (I) to (VI):

(I) disabling the data location transformer and the second FEC encoder;
(II) disabling the second FEC encoder and enabling the data location transformer;
(III) disabling the data location transformer and enabling HDD of the second FEC encoder;
(IV) disabling the data location transformer and enabling a configuration 2 of SDD of the second FEC encoder;
(V) disabling the data location transformer and enabling a configuration of the FEC encoder as a configuration 1 of SDD; or
(VI) enabling a configuration 1 of SDD of the second FEC encoder and enabling the data location transformer.

In some embodiments, the receiver apparatus is the receiver device shown in FIG. 2F and FIG. 2G, the transmitter apparatus includes a first FEC encoder, a second FEC encoder, and a data location transformer, and the second preset manner includes any one of the following (A) to (E):

(A) disabling the second FEC encoder and the data location transformer;
(B) disabling the second FEC encoder and enabling the data location transformer;
(C) disabling the data location inverse transformer and enabling HDD of the second FEC encoder;
(D) disabling the data location inverse transformer and enabling SDD of the second FEC encoder; or
(E) enabling SDD of the second FEC encoder and the data location transformer.

In some embodiments, the transmitter apparatus may be the transmitter device shown in any one of FIG. 2C to FIG. 2E and FIG. 2H to FIG. 2N, the transmitter apparatus includes a first FEC encoder, a second FEC encoder, a first interleaver, and a second interleaver, and the indication includes one of (I) to (VI):

(I) disabling the first interleaver, the second interleaver, and the second FEC encoder;
(II) disabling the second interleaver and the second FEC encoder, and enabling the first interleaver;
(III) disabling the second FEC encoder and enabling the first de-interleaver and the second interleaver;
(IV) disabling the first interleaver and the second de-interleaver, and enabling HDD of the second FEC encoder;
(V) disabling the first interleaver and the second interleaver, and enabling a configuration 2 of SDD of the second FEC encoder; or
(VI) disabling the first interleaver and the second interleaver, and enabling a configuration 1 of SDD of the second FEC encoder.

In some embodiments, the transmitter apparatus is the transmitter device shown in any one of FIG. 2H to FIG. 2N, and the transmitter apparatus includes a first FEC encoder, a second FEC encoder, a data location transformer, and a first interleaver, where the data location transformer is configured to perform a transform operation on a location of a received data bit or symbol. In this case, the second preset manner includes any one of the following (A) to (E):

(A) disabling the data location transformer, the second FEC encoder, and the first interleaver;
(B) disabling the data location transformer and the first interleaver, and enabling HDD of the second FEC encoder;
(C) disabling the first interleaver and enabling SDD of the second FEC encoder;

(D) disabling the data location transformer and enabling the first de-interleaver and SDD of the second FEC encoder; or

(E) enabling SDD of the second FEC encoder, the data location transformer, and the first interleaver.

In some embodiments, the transmitter apparatus may be the transmitter device shown in any one of FIG. 2L to FIG. 2N, and the transmitter apparatus includes a first FEC encoder, a second FEC encoder, a data location transformer, a first interleaver, and a second interleaver, where the data location transformer is configured to perform a transform operation on a location of a received data bit or symbol. The indication may include any one of the following:

(I) disabling the data location transformer, the second FEC encoder, the first interleaver, and the second interleaver;
(II) disabling the data location transformer, the second interleaver, and the first interleaver, and enabling HDD of the second FEC encoder;
(III) disabling the data location transformer, the second interleaver, and the first interleaver, and enabling SDD of the second FEC encoder;
(IV) disabling the first interleaver and enabling SDD of the second FEC encoder; or
(V) enabling SDD of the second FEC encoder.

In some embodiments, the transmitter apparatus is the transmitter device shown in any one of FIG. 2L to FIG. 2N, and the transmitter apparatus includes a first FEC encoder, a second FEC encoder, a data location transformer, a first interleaver, and a second interleaver, where the data location transformer is configured to perform a transform operation on a location of a received data bit or symbol. The second preset manner includes any one of the following (A) to (E):

(A) disabling the data location inverse transformer, the second FEC decoder, the first de-interleaver, and the second de-interleaver;
(B) disabling the data location inverse transformer, the second de-interleaver, and the first de-interleaver, and enabling HDD of the second FEC decoder;
(C) disabling the data location inverse transformer, the second de-interleaver, and the first de-interleaver, and enabling SDD of the second FEC decoder;
(D) disabling the first de-interleaver and enabling SDD of the second FEC decoder; or
(E) enabling SDD of the second FEC decoder and the first de-interleaver.

An interleaving delay and/or power consumption of a configuration 1 of the first interleaver is higher than an interleaving delay and/or power consumption of a configuration 2 of the first interleaver, an error correction capability a configuration 1 of the SDD of the second FEC encoder is higher than an error correction capability of a configuration 2 of the SDD of the second FEC encoder, and the error correction capability of the configuration 2 is higher than an error correction capability of the HDD of the second FEC encoder. Error correction capabilities of the first interleaver, the second interleaver, and the second FEC encoder are higher than a function of the data location transformer.
In some embodiments, the transmitter apparatus and the receiver apparatus may jointly adjust a capability of performing error correction on a data stream. To be specific, the receiver device adjusts a capability of performing error correction on a data stream based on a first trigger condition, and the transmitter device adjusts a capability of performing error correction on a to-be-sent data stream based on a second trigger condition.
In some embodiments, if the transmission information meets the trigger condition, when the error correction capability of the receiver apparatus is adjusted, a connection between the transmitter apparatus and the receiver apparatus may be interrupted. After the adjustment is completed, the connection is re-established by using an adjusted configuration, and transmission of the data stream is performed based on an adjusted error correction capability of the receiver apparatus.
Concatenated code manners in FIG. 1 to FIG. 2N can effectively improve a data stream transmission process with a high bit error ratio. However, when a bit error ratio of data stream transmission is low in some scenarios, such as data stream transmission between devices in a data center, data stream transmission in high-speed computing, and artificial intelligence (artificial intelligence, AI), or when a bit error ratio fluctuation of data stream transmission is small in some scenarios, a reliability requirement in a standard can be met without a concatenated code. Therefore, embodiments of this application provide a method for disabling some components or weakening error correction capabilities of some components.
In the concatenated code scenarios shown in FIG. 1 to FIG. 2N, the second FEC decoder may perform decoding in an HDD manner and an SDD manner. In the scenarios, adjustment manners are shown in Table 1. To obtain an optimal error correction capability of decoding, the configuration 1 of the SDD of the second FEC decoder may be enabled. When the error correction capability of the second FEC decoder needs to be weakened, the configuration 2 of the SDD of the second FEC decoder may be enabled. Compared with the configuration 1, the configuration 2 of the soft decoding of the second FEC decoder has a lower delay and/or lower power consumption. This can be achieved by reducing a test pattern (test pattern) and/or changing a decoding algorithm. Error correction performance of the configuration 2 of the soft decoding of the second FEC decoder is weaker, but is still stronger than error correction performance of the hard decoding of the second FEC decoder. Therefore, a data stream transmission delay and power consumption can be reduced by disabling the second FEC decoder, weakening the error correction capability of the second FEC decoder, or the like. For weakening the error correction capability of the second FEC decoder, an error correction capability in the SDD manner of the second FEC decoder may be reduced to reduce the data stream transmission delay and the power consumption, or the SDD manner of the second FEC decoder may be replaced with the hard decoding manner.

Table 1: Adjustment manners for the concatenated code scenarios illustrated from FIG. 1 to FIG. 2N

| Adjustment manner | Second FEC decoder |
| --- | --- |
| Manner 1 | Enable a configuration 1 of SDD of the second FEC decoder |
| Manner 2 | Enable a configuration 2 of SDD of the second FEC decoder |
| Manner 3 | Disable the second FEC decoder |

In the concatenated code scenario shown in any one of FIG. 2A to FIG. 2E and FIG. 2H to FIG. 2N, the data stream transmission delay and the power consumption can be reduced in one or more manners of the following: disabling the second FEC decoder, disabling the interleaver, weakening an interleaving effect of the interleaver, and weakening the error correction capability of the second FEC decoder. Specific adjustment manners are shown in Table 2.

During decoding, the second FEC decoder and the first FEC decoder both collect statistics on a quantity of bit errors, to set control information based on the quantity of bit errors and a determining threshold, where the control information indicates disabling information. In some embodiments, the disabling information includes a disenable_indicator control parameter, and the disenable_indicator control parameter indicates the following adjustment manners in receiver and transmitter devices:

Table 2: Adjustment manners for the concatenated code scenarios illustrated from any one of FIG. 2A to FIG. 2E and FIG. 2H to FIG. 2N

| Adjustment manner | Second FEC decoder | First de-interleaver |
| --- | --- | --- |
| Manner 1 | Enable a configuration 1 of SDD of the second FEC decoder | Enable a configuration 1 of the first de-interleaver |
| Manner 2 | Enable a configuration 1 of SDD of the second FEC decoder | Enable a configuration 2 of the first de-interleaver |
| Manner 3 | Enable a configuration 1 of SDD of the second FEC decoder | Disable the first de-interleaver |
| Manner 4 | Enable a configuration 2 of SDD of the second FEC decoder | Disable the first de-interleaver |
| Manner 5 | Enable HDD the second FEC decoder | Disable the first de-interleaver |
| Manner 6 | Disable the second FEC decoder | Disable the first de-interleaver |

In some embodiments, the first interleaver and/or the second interleaver are/is a convolutional interleaver. When the convolutional interleaver is enabled, convolutional interleaving with different delays may be configured via a register, that is, a delay of interleaving in each row is set. Table 2 provides examples of two types of convolutional interleaver configurations with different delays: the configuration 1 and the configuration 2, where a convolutional interleaving delay and/or power consumption of the configuration 1 are/is higher than a convolutional interleaving delay and/or power consumption of the configuration 2. In some embodiments, there may be more than two types of convolutional interleaver configurations. For example, in addition to the foregoing configurations 1 and 2, configurations 3, 4, ..., and n with a lower delay and/or lower power consumption may be further included.

Because power consumption and/or a delay of the convolutional interleaver is higher than power consumption and/or a delay of the soft decoding of the second FEC decoder, lowering the configuration of the convolutional interleaving or disabling the convolutional interleaving is preferentially considered. The configuration 2 of the convolutional interleaving has a lower delay and/or lower power consumption than the configuration 1. This can be achieved by reducing a quantity of registers or modifying a parameter. Correspondingly, an interleaving effect of the configuration 2 is reduced, and error correction performance is weaker.

In some embodiments, the second FEC encoder and the second FEC decoder in FIG. 1 to FIG. 2N are both disabled or enabled. In other words, when the second FEC decoder is disabled, the second FEC encoder is also disabled; or when the second FEC decoder is enabled, the second FEC encoder is also enabled.

In some embodiments, the interleaver and the de-interleaver shown in any one of FIG. 2A to FIG. 2E and FIG. 2H to FIG. 2N are both enabled or disabled. In other words, when the de-interleaver is disabled, the interleaver is also disabled; or when the de-interleaver is enabled, the interleaver is also enabled.

If the quantity of bit errors of the first FEC decoder is not considered for determining, and only the quantity of bit errors of the second FEC decoder and the threshold are used for determining, in some embodiments, the quantity of bit errors and the threshold may be processed in a unit of a codeword, a bit, a symbol, or a bit group including any quantity of bits. For example, the codeword is used as a unit. In the receiver device shown in any one of FIG. 2A to FIG. 2E and FIG. 2H to FIG. 2N, various adjustment manners based on Table 2 are as follows:

(1) if a quantity of bit errors in P codewords at the second FEC decoder is less than J, disabling the de-interleaver (the first de-interleaver and/or the second de-interleaver shown in any one of FIG. 2A to FIG. 2E and FIG. 2H to FIG. 2N) and the second FEC decoder, where P and J are positive integers and P>J>1;
(2) if a quantity of bit errors in P codewords at the second FEC decoder is less than K, disabling the de-interleaver (the first de-interleaver and/or the second de-interleaver shown in any one of FIG. 2A to FIG. 2E and FIG. 2H to FIG. 2N) and enabling the HDD of the second FEC decoder, where K is a positive integer and K>J;
(3) if a quantity of bit errors in P codewords at the second FEC decoder is less than L, disabling the de-interleaver (the first de-interleaver and/or the second de-interleaver shown in any one of FIG. 2A to FIG. 2E and FIG. 2H to FIG. 2N) and enabling the configuration 2 of the SDD of the second FEC decoder, where L is a positive integer and L>K;
(4) if a quantity of bit errors in P codewords at the second FEC decoder is less than M, disabling the de-interleaver (the first de-interleaver and/or the second de-interleaver shown in any one of FIG. 2A to FIG. 2E and FIG. 2H to FIG. 2N) and enabling the configuration 1 of the SDD of the second FEC decoder, where M>L;
(5) if a quantity of bit errors in P codewords at the second FEC decoder is less than N, enabling a configuration of the FEC decoder as the configuration 1 of the SDD and enabling the configuration 2 of the de-interleaver (the first de-interleaver and/or the second de-interleaver shown in any one of FIG. 2A to FIG. 2E and FIG. 2H to FIG. 2N), where N>M; or
(6) if none of (1) to (5) is met, enabling the configuration 1 of the second FEC decoder and enabling the configuration 1 of the de-interleaver (the first de-interleaver and/or the second de-interleaver shown in any one of FIG. 2A to FIG. 2E and FIG. 2H to FIG. 2N).

In some embodiments, a quantity of occurrences may be set for a trigger condition of each adjustment manner, quantities of occurrences of trigger conditions may be the same or different, and adjustment is triggered only when a quantity threshold of occurrences of each trigger condition is met.

Multi-condition switching between these adjustment manners may be implemented via a state machine. The adjustment manner switching may be automatically performed when communication between a receiver and a transmitter is just established, or may be performed in a communication process because a switching condition is met. During the switching, a connection may be reset or synchronization locking may be reperformed, and then communication may be performed in a switched manner. Specifically, there are two switching manners. One is switching from a default high bit error state to a low bit error state, and the other is switching from a default low bit error state to a high bit error state. Switching from the default high bit error state to the low bit error state means that a system default configuration before communication establishment is the high bit error state. If an actual bit error ratio of a channel after the communication establishment meets the high bit error state, switching is not needed. If an actual bit error ratio of a channel is extremely low, a configuration is switched. Switching from the default low bit error state to the high bit error state means that a system default configuration before communication establishment is the low bit error state. If an actual bit error ratio of a channel after the communication establishment meets the low bit error state, switching is not needed. If an actual bit error ratio of a channel is high, a configuration is switched.

In embodiments of this application, "disabling" includes "closing" or "bypassing", and "enabling" includes "enabling on hardware" or "enabling on software".

In some embodiments, "disabling the second FEC decoder" in the adjustment manner may be (1) closing the second FEC decoder, or (2) not decoding the data stream by the second FEC decoder while not closing the second FEC decoder, in other words, enabling the configuration 1 of the SDD, the configuration 2 of the SDD, or the HDD of the second FEC decoder. When "disabling the second FEC decoder" is (1) closing the second FEC decoder, transmission power consumption can be effectively reduced.

In some embodiments, "disabling the de-interleaver" in the adjustment manner may be (1) closing the de-interleaver, or (2) not processing the data stream by the de-interleaver while not closing the de-interleaver, in other words, enabling the configuration 1 or the configuration 2 of the de-interleaver. When "disabling the de-interleaver" in the adjustment manner is (1) closing the de-interleaver, transmission power consumption can be effectively reduced.

An embodiment of this application further provides an apparatus for processing an Ethernet data stream. FIG. 4 is a diagram of a structure of an apparatus for processing an Ethernet data stream according to an embodiment of this application. Based on a plurality of modules shown in FIG. 4, the apparatus that is for processing the Ethernet data stream and that is shown in FIG. 4 can perform all or some operations in the method embodiment shown in FIG. 3. It should be understood that the apparatus may include more additional modules than the shown modules or a part of the shown modules may be omitted. This is not limited in this embodiment of this application. The apparatus in FIG. 4 is a receiver apparatus. As shown in FIG. 4, the apparatus includes an obtaining module 401 and an adjustment module 402. The obtaining module 401 is configured to obtain transmission information of a first data stream. The adjustment module 402 is configured to: if the transmission information meets a trigger condition, adjust an error correction capability of the receiver apparatus.

In some embodiments, the obtaining module 401 and the adjustment module 402 may be a same logical module or physical circuit, for example, located in a same chip.

In some embodiments, the transmission information includes one or more of a bit error ratio BER, a quantity of error bits, a symbol error ratio SER, a quantity of error symbols, a codeword error ratio CER, a quantity of error codewords, channel state information, and an eye pattern parameter of the first data stream.

In some embodiments, the receiver apparatus further includes a first de-interleaver, and if the transmission information meets the trigger condition, adjusting the error correction capability of the receiver apparatus includes one or more of (1) to (6):

(1) if a quantity of bit errors in P codewords at a second FEC decoder is less than J, disabling the first de-interleaver and the second FEC decoder, where P and J are positive integers and $P>J>1$;

(2) if a quantity of bit errors in P codewords at a second FEC decoder is less than K, disabling the first de-interleaver and enabling hard decision decoding HDD of the second FEC decoder, where K is a positive integer and $K>J$;

(3) if a quantity of bit errors in P codewords at a second FEC decoder is less than L, disabling the first de-interleaver and enabling a configuration 2 of soft decision decoding SDD of the second FEC decoder, where L is a positive integer and $L>K$;

(4) if a quantity of bit errors in P codewords at a second FEC decoder is less than M, disabling the first de-interleaver and enabling a configuration 1 of SDD of the second FEC decoder, where $M>L$;

(5) if a quantity of bit errors in P codewords at a second FEC decoder is less than N, enabling a configuration of the FEC decoder as a configuration 1 of SDD and enabling a configuration 2 of the first de-interleaver, where $N>M$; or

(6) if none of (1) to (5) is met, enabling a configuration 1 of a second FEC decoder and enabling a configuration 1 of the first de-interleaver.

In some embodiments, if the transmission information meets the trigger condition, adjusting the error correction capability of the receiver apparatus includes any one of the following:

(1) enabling a configuration 1 of soft decision decoding SDD of a second FEC decoder;

(2) enabling a configuration 2 of SDD of a second FEC decoder;

(3) enabling hard decision decoding HDD of a second FEC decoder; or

(4) disabling a second FEC decoder.

An error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder.

In some embodiments, the receiver apparatus further includes a first de-interleaver, and if the transmission information meets the trigger condition, adjusting the error correction capability of the receiver apparatus includes any one of the following:

(1) enabling a configuration 1 of soft decision decoding SDD of a second FEC decoder and enabling a configuration 1 of the first de-interleaver;

(2) enabling a configuration 1 of SDD of a second FEC decoder and enabling a configuration 2 of the first de-interleaver;

(3) enabling a configuration 1 of SDD of a second FEC decoder and disabling the first de-interleaver;

(4) enabling a configuration 2 of SDD of a second FEC decoder and disabling the first de-interleaver;

(5) enabling hard decision decoding HDD of a second FEC decoder and disabling the first de-interleaver; or

(6) disabling a second FEC decoder and the first de-interleaver.

A de-interleaving delay and/or power consumption of the configuration 1 of the first de-interleaver is higher than a de-interleaving delay and/or power consumption of the configuration 2 of the first de-interleaver, an error correction capability of the configuration 1 of the SDD of the second FEC decoder is higher than an error correction capability of the configuration 2 of the SDD of the second FEC decoder, and the error correction capability of the configuration 2 is higher than an error correction capability of the HDD of the second FEC decoder.

In some embodiments, the receiver apparatus further includes a data location inverse transformer, a first de-interleaver, and a second de-interleaver, where the data location inverse transformer is configured to perform an inverse transform operation on a location of a received data bit or symbol whose location is transformed by a data location transformer, and if the transmission information meets the trigger condition, adjusting the error correction capability of the receiver apparatus includes any one of the following:

(1) if a bit error ratio BER of a data stream received by the receiver apparatus satisfies BER≤a, disabling the data location inverse transformer, a second FEC decoder, the first de-interleaver, and the second de-interleaver, where a>0;

(2) if a BER of a data stream received by the receiver apparatus satisfies a<BER≤b, disabling the data location inverse transformer, the second de-interleaver, and the first de-interleaver, and enabling hard decision decoding HDD of a second FEC decoder;

(3) if a BER of a data stream received by the receiver apparatus satisfies b<BER≤c, disabling the data location inverse transformer, the second de-interleaver, and the first de-interleaver, and enabling soft decision decoding SDD of a second FEC decoder;

(4) if a BER of a data stream received by the receiver apparatus satisfies c<BER≤d, disabling the first de-interleaver and enabling soft decision decoding SDD of a second FEC decoder; or

(5) if a BER of a data stream received by the receiver apparatus satisfies d<BER≤e, enabling soft decision decoding SDD of a second FEC decoder.

In some embodiments, the transmission information is related to a quantity of error units at a first FEC decoder and/or a quantity of error units at the second FEC decoder. The error unit includes a codeword, a bit, a symbol, or a bit group including any quantity of bits.

In some embodiments, the transmission information includes information about how to adjust the error correction capability of the receiver apparatus.

In some embodiments, the information about how to adjust the error correction capability of the receiver apparatus includes: disabling or weakening an error correction capability of the second FEC decoder.

In some embodiments, the receiver apparatus further includes the de-interleaver, and the information about how to adjust the error correction capability of the receiver apparatus includes: disabling or weakening an error correction capability of the second FEC decoder; and/or disabling or weakening a de-interleaving effect of the de-interleaver.

In some embodiments, the receiver apparatus further includes the de-interleaver and the data location inverse transformer, and the information about how to adjust the error correction capability of the receiver apparatus includes: disabling or weakening an error correction capability of the second FEC decoder; disabling or weakening a de-interleaving effect of the de-interleaver; and/or disabling a function of the data location inverse transformer.

In some embodiments, the transmission information is in a register of the transmitter apparatus and/or the transmission information is triggered by a primitive.

As shown in FIG. 5, an embodiment of this application further provides an apparatus for processing an Ethernet data stream, which is in a transmitter apparatus. The apparatus includes a configuration module. The configuration module is configured to configure a data stream processing manner of the transmitter apparatus based on a second indication.

In some embodiments, the indication includes information about how to adjust the data stream processing manner of the transmitter apparatus. In some embodiments, the indication includes disabling or weakening an error correction capability of a second FEC decoder.

In some embodiments, the transmitter apparatus further includes a first interleaver, and the indication includes: disabling or weakening an error correction capability of a second FEC decoder; and/or disabling or weakening an interleaving effect of the first interleaver.

In some embodiments, the transmitter apparatus further includes a first interleaver and a data location transformer, and the indication includes disabling or weakening an error correction capability of a second FEC decoder; disabling or weakening an interleaving effect of the first interleaver; and/or disabling a function of the data location transformer.

In some embodiments, the indication is from a receiver apparatus corresponding to the transmitter apparatus.

In some embodiments, the indication is in a register of the transmitter apparatus and/or the indication is triggered by a primitive.

In some embodiments, the apparatus in FIG. 4 and/or FIG. 5 is located in an Ethernet interface or a chip. In some embodiments, the Ethernet interface including the apparatus is located in a computing device. The computing device may be a network device or a server, and the network device may be a routing device or a switching device.

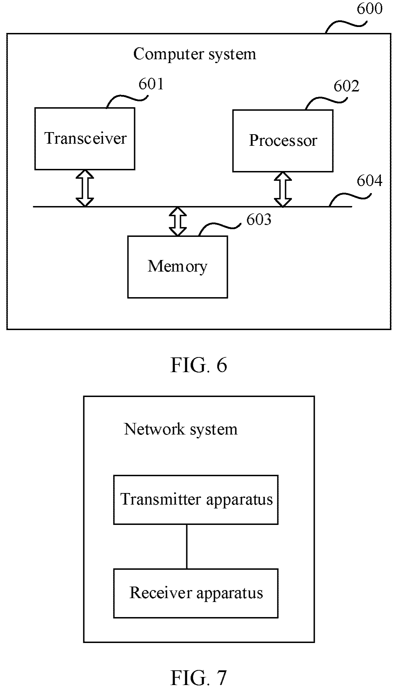

As shown in FIG. 6, an embodiment of this application further provides a computer system 600. The system 600 includes a transceiver 601, a processor 602, and a memory 603. The transceiver 601, the processor 602, and the memory 603 are connected through a bus 604. The transceiver 601 is configured to: receive a packet and send a packet. The memory 603 is configured to store instructions or program code. The processor 602 is configured to invoke the instructions or the program code in the memory 603, to enable a device to perform related processing steps of a first module or a second module in the foregoing method embodiments. In a specific embodiment, the computer system 600 in this embodiment of this application may correspond to the first module or the second module in the foregoing method embodiments. The processor 602 in the computer system 600 reads the instructions or the program code in the memory 603, to enable the computer system 600 shown in FIG. 6 to perform all or some of the operations in the method embodiment performed by the receiver apparatus and/or the transmitter apparatus.

The computer system 600 may alternatively correspond to the apparatus shown in FIG. 4 or FIG. 5. For example, the obtaining module 401 in FIG. 4 and FIG. 5 is equivalent to the transceiver 601, and the adjustment module 402 or the configuration module is equivalent to some or all functions of the processor 602.

As shown in FIG. 7, a network system in an embodiment of this application includes a transmitter apparatus and a receiver apparatus. The transmitter apparatus is the apparatus in the embodiment corresponding to FIG. 5 or FIG. 6, and the receiver apparatus is the apparatus in the embodiment corresponding to FIG. 4 or FIG. 6.

In some embodiments, the processor or the chip may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, any conventional processor, or the like. It should be noted that the processor may be a processor that supports an advanced reduced instruction set computing machines (advanced RISC machines, ARM) architecture.

In an optional embodiment, the memory may include a read-only memory and a random access memory, and provides the instructions and data for the processor. The memory may further include a non-volatile random access memory. For example, the memory may further store information of a device type.

The memory may be a volatile memory or a non-volatile memory, or may include both a volatile memory and a non-volatile memory. The non-volatile memory may be a ROM, a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a RAM, and serves as an external cache. By way of example but not limitative description, many forms of RAMs are available, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

In some embodiments, the computer system 700 may be a network device or a server. For example, the network device may be a routing device or a switching device.

An embodiment of this application further provides a computer-readable storage medium. The computer-readable storage medium stores at least one program instruction or code, and the program instruction or the code is executed by a computer, to obtain and separately send the status information and the control information in Embodiment 1 or 2, or send the status information and the control information together.

All or some of the foregoing embodiments may be implemented by using software, hardware, firmware, or any combination thereof. When the software is used to implement embodiments, all or some of embodiments may be implemented in a form of a computer program product. The computer program product includes one or more computer instructions. When the computer program instructions are loaded and executed on a computer, all or some of the procedures or functions according to this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium (for example, a solid-state drive (solid state disk, SSD)), or the like.

To clearly describe interchangeability of hardware and software, the steps and compositions of embodiments have been generally described in the foregoing descriptions based on functions. Whether the functions are performed by the hardware or the software depends on particular applications and design constraint conditions of the technical solutions. A person of ordinary skill in the art may use different methods to implement the described functions for each particular application, but it should not be considered that the implementation goes beyond the scope of this application.

Computer program code used to implement the method in embodiments of this application may be written in one or more programming languages. The computer program code may be provided for a processor of a general-purpose computer, a dedicated computer, or another programmable apparatus for searching for an alignment marker, so that when the program code is executed by the computer or the another programmable apparatus for searching for the alignment marker, functions/operations specified in the flowcharts and/or block diagrams are implemented. The program code may be executed entirely on a computer, partly on a computer, as a standalone software package, partly on a computer and partly on a remote computer, or entirely on a remote computer or a server.

In the context of embodiments of this application, the computer program code or related data may be carried in any appropriate carrier, so that the device, the apparatus, or the processor can perform various types of processing and operations described above. Examples of the carrier include a signal, a computer-readable medium, and the like. Examples of the signal may include an electrical signal, an optical signal, a radio signal, a voice signal, or other forms of propagated signals, such as a carrier wave and an infrared signal.

It may be clearly understood by a person skilled in the art that, for the purpose of convenient and brief description, for detailed working processes of the foregoing described system, device, and module, refer to corresponding processes in the foregoing method embodiments. Details are not described herein again.

In the several embodiments provided in this application, it should be understood that the disclosed system, device, and method may be implemented in other manners. For example, the foregoing described device embodiments are merely examples. For example, division into the modules is merely logical function division and may be other division in actual implementation. For example, a plurality of modules or components may be combined or integrated into another system, or some features may be ignored or not performed. In addition, the displayed or discussed mutual couplings or direct couplings or communication connections may be implemented through some interfaces. The indirect couplings or communication connections between the devices or modules may be implemented in electrical, mechanical, or other forms.

The modules described as separate parts may or may not be physically separate, and parts displayed as modules may or may not be physical modules, that is, may be located in one position, or may be distributed on a plurality of network modules. Some or all of the modules may be selected based on actual needs to achieve the objectives of the solutions of embodiments of this application.

In addition, functional modules in embodiments of this application may be integrated into one processing module, each of the modules may exist alone physically, or two or more modules may be integrated into one module. The integrated module may be implemented in a form of hardware, or may be implemented in a form of a software functional module.

In this application, terms such as "first" and "second" are used to distinguish between same items or similar items that have basically same functions. It should be understood that there is no logical or time sequence dependency between "first", "second", and "nth", and a quantity and an execution sequence are not limited. It should be further understood that although the following descriptions use terms such as first and second to describe various elements, these elements should not be limited by the terms. These terms are merely used to distinguish one element from another. For example, the first module may be referred to as the second module without departing from the scope of the various examples, and similarly, the second module may be referred to as the first module.

It should be further understood that sequence numbers of the processes do not mean execution sequences in embodiments of this application. The execution sequences of the processes should be determined based on functions and internal logic of the processes, and should not constitute any limitation on implementation processes of embodiments of this application.

In this application, the term "at least one" means one or more, and the term "a plurality of" in this application means two or more. For example, a plurality of code blocks mean two or more code blocks. The terms "system" and "network" are often used interchangeably in this specification.

It should be understood that the terms used in the descriptions of the various examples in this specification are merely intended to describe specific examples but are not intended to constitute a limitation. For example, "a ("a" and "an")" and "the" of singular forms used in the descriptions of the various examples and the appended claims are intended to include plural forms, unless otherwise specified in the context clearly.

It should be further understood that the term "include" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or combinations thereof not excluded.

It should be further understood that, depending on the context, the phrase "if determining..." or "if detecting [a stated condition or event]" may be interpreted to mean "when determining...", "in response to determining...", "when detecting [the stated condition or event]", or "in response to detecting [the stated condition or event]".

It should be understood that determining B based on A does not mean that B is determined based only on A. B may alternatively be determined based on A and/or other information.

It should be further understood that "one embodiment", "an embodiment", and "a possible implementation" mentioned throughout the specification mean that particular features, structures, or characteristics related to the embodiment or the implementation are included in at least one embodiment of this application. Therefore, "in one embodiment", "in an embodiment", or "a possible implementation" appearing throughout the specification may not necessarily refer to a same embodiment. In addition, these particular features, structures, or characteristics may be combined in one or more embodiments in any appropriate manner.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A communication method, applied to a receiver apparatus comprising a de-interleaver, wherein the method comprises: adjusting an error correction capability of the de-interleaver.

2. The method according to claim 1, wherein the adjusting the error correction capability of the de-interleaver comprises: disabling the de-interleaver or weakening a de-interleaving effect of the de-interleaver.

3. The method according to claim 2, wherein the disabling the de-interleaving comprises:
   bypassing the de-interleaver.

4. The method according to any one of claims 1 to 3, wherein the de-interleaver is a convolutional de-interleaver.

5. The method according to any one of claims 1 to 4, wherein the adjusting the error correction capability of the de-interleaver comprises: adjusting the error correction capability of the de-interleaver based on an indication.

6. The method according to claim 5, wherein the adjusting the error correction capability of the de-interleaver based on the indication comprises: adjusting the error correction capability of the de-interleaver based on a manually triggered indication.

7. The method according to claim 5 or 6, wherein the indication is in a register of the communication apparatus and/or is triggered by a primitive.

8. The method according to any one of claims 1 to 7, wherein the method further comprises:

   receiving a first data stream sent by a transmitter apparatus; and
   adjusting the error correction capability of the de-interleaver based on transmission information of the first data stream.

9. The method according to claim 8, wherein the transmission information comprises one or more of a bit error ratio BER, a quantity of error bits, a symbol error ratio SER, a quantity of error symbols, a codeword error ratio CER, a quantity of error codewords, channel state information, and an eye pattern parameter of the first data stream.

10. The method according to claim 8 or 9, wherein the method further comprises: if the transmission information meets a trigger condition, adjusting the error correction capability of the de-interleaver.

11. The method according to any one of claims 8 to 10, wherein the transmission information comprises information about how to adjust an error correction capability of the receiver apparatus.

12. The method according to any one of claims 1 to 11, wherein the receiver apparatus comprises a second FEC decoder, and the second FEC encoder is an inner code decoder of a concatenated code.

13. The method according to claim 12, wherein the receiver apparatus further comprises a first FEC decoder, the first FEC decoder is an outer code encoder of the concatenated code, and the de-interleaver is located between the first FEC decoder and the second FEC decoder over a transmission path of the data stream.

14. The method according to claim 12 or 13, wherein the method further comprises: adjusting an error correction capability of the second FEC encoder.

15. The method according to claim 14, wherein the adjusting the error correction capability of the second FEC encoder comprises: disabling the second FEC decoder, disabling an error correction capability of the second FEC decoder, or weakening the error correction capability of the second FEC decoder.

16. The method according to claim 15, wherein the disabling the second FEC decoder comprises: bypassing the second FEC decoder.

17. The method according to any one of claims 1 to 16, wherein the receiver apparatus further comprises a data location inverse transformer, and the method further comprises: disabling the data location inverse transformer.

18. A communication method, applied to a transmitter apparatus comprising an interleaver, wherein the method comprises:
disabling the interleaver or weakening an interleaving effect of the interleaver.

19. The method according to claim 18, wherein the disabling the interleaver comprises: bypassing the interleaver.

20. The method according to claim 18 or 19, wherein the interleaver is a convolutional interleaver.

21. The method according to any one of claims 18 to 20, wherein the disabling the interleaver or weakening the interleaving effect of the interleaver comprises: disabling the interleaver or weakening the interleaving effect of the interleaver based on an indication.

22. The method according to claim 21, wherein the indication is from a receiver apparatus corresponding to the transmitter apparatus.

23. The method according to claim 21 or 22, wherein the indication is in a register of the transmitter apparatus and/or the indication is triggered by a primitive.

24. The method according to any one of claims 18 to 23, wherein the transmitter apparatus further comprises a second FEC encoder, and the second FEC encoder is an inner code encoder of a concatenated code.

25. The method according to claim 24, wherein the transmitter apparatus further comprises a first FEC encoder, the first FEC encoder is an outer code encoder of the concatenated code, and the interleaver is located between the first FEC encoder and the second FEC encoder over a transmission direction of a data stream.

26. The method according to claim 24 or 25, wherein the method further comprises: disabling the second FEC encoder or weakening a capability of the second FEC encoder.

27. The method according to claim 26, wherein the disabling the second FEC encoder comprises: bypassing the second FEC encoder.

28. The method according to claims 18 to 27, wherein the transmitter apparatus further comprises a data location transformer, and the method further comprises: disabling the data location transformer.

29. A receiver apparatus, comprising a de-interleaver, wherein the receiver apparatus is configured to:
adjust an error correction capability of the de-interleaver.

30. The receiver apparatus according to claim 29, wherein the adjusting the error correction capability of the de-interleaver comprises:
disabling the de-interleaver or weakening a de-interleaving effect of the de-interleaver.

31. The receiver apparatus according to claim 30, wherein the disabling the de-interleaving comprises: bypassing the de-interleaver.

32. The receiver apparatus according to claim 29 or 30, wherein the de-interleaver is a convolutional de-interleaver.

33. The receiver apparatus according to any one of claims 29 to 32, wherein the adjusting the error correction capability of the de-interleaver comprises: adjusting the error correction capability of the de-interleaver based on an indication.

34. The receiver apparatus according to claim 33, wherein the adjusting the error correction capability of the de-interleaver based on the indication comprises: adjusting the error correction capability of the de-interleaver based on a manually triggered indication.

35. The receiver apparatus according to claim 33 or 34, wherein the indication is in a register of the communication apparatus and/or is triggered by a primitive.

36. The receiver apparatus according to any one of claims 29 to 35, wherein the receiver apparatus is further configured to:

    receive a first data stream sent by a transmitter apparatus; and
    adjust the error correction capability of the de-interleaver based on transmission information of the first data stream.

37. The receiver apparatus according to claim 36, wherein the transmission information comprises one or more of a bit error ratio BER, a quantity of error bits, a symbol error ratio SER, a quantity of error symbols, a codeword error ratio CER, a quantity of error codewords, channel state information, and an eye pattern parameter of the first data stream.

38. The receiver apparatus according to claim 36 or 37, wherein the receiver apparatus is further configured to: if the transmission information meets a trigger condition, adjust the error correction capability of the de-interleaver.

39. The receiver apparatus according to any one of claims 36 to 38, wherein the transmission information comprises information about how to adjust an error correction capability of the receiver apparatus.

40. The receiver apparatus according to any one of claims 29 to 39, wherein the receiver apparatus comprises a second FEC decoder, and the second FEC encoder is an inner code decoder of a concatenated code.

41. The receiver apparatus according to claim 40, wherein the receiver apparatus further comprises a first FEC decoder, the first FEC decoder is an outer code encoder of the concatenated code, and the de-interleaver is located between the first FEC decoder and the second FEC decoder over a transmission path of the data stream.

42. The receiver apparatus according to claim 41 or 42, wherein the receiver apparatus is further configured to: adjust an error correction capability of the second FEC encoder.

43. The receiver apparatus according to claim 42, wherein the adjusting the error correction capability of the second FEC encoder comprises: disabling the second FEC decoder, disabling an error correction capability of the second FEC decoder, or weakening the error correction capability of the second FEC decoder.

44. The receiver apparatus according to claim 43, wherein the disabling the second FEC decoder comprises: bypassing the second FEC decoder.

45. The receiver apparatus according to any one of claims 29 to 44, wherein the receiver apparatus further comprises a data location inverse transformer, and the method further comprises: disabling the data location inverse transformer.

46. A transmitter apparatus, comprising an interleaver, wherein the transmitter apparatus is configured to: disable the interleaver or weaken an interleaving effect of the interleaver.

47. The transmitter apparatus according to claim 46, wherein the disabling the interleaver comprises: bypassing the interleaver.

48. The transmitter apparatus according to claim 46 or 47, wherein the interleaver is a convolutional interleaver.

49. The transmitter apparatus according to any one of claims 46 to 48, wherein the disabling the interleaver or weakening the interleaving effect of the interleaver is used to disable the interleaver or weaken the interleaving effect of the interleaver based on an indication.

50. The transmitter apparatus according to claim 49, wherein the indication is from a receiver apparatus corresponding to the transmitter apparatus.

51. The transmitter apparatus according to claim 49 or 50, wherein the indication is in a register of the transmitter apparatus and/or the indication is triggered by a primitive.

52. The transmitter apparatus according to any one of claims 46 to 51, wherein the transmitter apparatus further comprises a second FEC encoder, and the second FEC encoder is an inner code encoder of a concatenated code.

53. The transmitter apparatus according to claim 52, wherein the transmitter apparatus further comprises a first FEC encoder, the first FEC encoder is an outer code encoder of the concatenated code, and the interleaver is located between the first FEC encoder and the second FEC encoder over a transmission direction of a data stream.

54. The transmitter apparatus according to claim 52 or 53, wherein the transmitter apparatus is further configured to: disable the second FEC encoder or weaken a capability of the second FEC encoder.

55. The transmitter apparatus according to claim 54, wherein the disabling the second FEC encoder comprises: bypassing the second FEC encoder.

56. The transmitter apparatus according to any one of claims 46 to 55, wherein the transmitter apparatus further comprises a data location transformer, and the transmitter apparatus is further configured to: disable the data location transformer.

57. A communication system, comprising the receiver apparatus according to any one of claims 29 to 45 and the transmitter apparatus according to any one of claims 46 to 56.

58. A computer-readable storage medium, wherein the computer-readable storage medium stores instructions, and when the instructions are run by a processor, the method according to any one of claims 1 to 28 is implemented.

59. A computer program product, wherein the computer program product comprises a computer program, and when the computer program is run by a processor, the method according to any one of claims 1 to 28 is implemented.

First FEC encoder → Second FEC encoder → Channel → Second FEC decoder → First FEC decoder

Transmitter device

Receiver device

FIG. 1

First FEC encoder → First interleaver → Second FEC encoder → Channel → Second FEC decoder → First de-interleaver → First FEC decoder

Transmitter device

Receiver device

FIG. 2A

First FEC encoder → Second FEC encoder → First interleaver → Channel → First de-interleaver → Second FEC decoder → First FEC decoder

Transmitter device

Receiver device

FIG. 2B

```
┌─────────────────────────────────────────────────────┐        ┌──────────────────────────────────────────────────────┐
│ ┌────────┐   ┌────────┐   ┌────────┐   ┌────────┐     │        │ ┌──────────┐  ┌────────┐   ┌──────────┐  ┌────────┐   │
│ │ First  │   │ First  │   │ Second │   │ Second │     │Channel │ │ Second de-│ │ Second │   │ First de- │ │ First  │   │
│ │ FEC    │→  │interleaver│→│ FEC    │→  │interleaver│  │──────→ │ │interleaver│→│ FEC    │→  │interleaver│→│ FEC    │   │
│ │ encoder│   │        │   │ encoder│   │        │     │        │ │          │  │ decoder│   │          │  │ decoder│   │
│ └────────┘   └────────┘   └────────┘   └────────┘     │        │ └──────────┘  └────────┘   └──────────┘  └────────┘   │
│                  Transmitter device                   │        │                    Receiver device                    │
└─────────────────────────────────────────────────────┘        └──────────────────────────────────────────────────────┘
```

FIG. 2C

FIG. 2D

**Transmitter device:** First FEC encoder → First interleaver → Second interleaver → Second FEC encoder

**Channel**

**Receiver device:** Second FEC decoder → Second de-interleaver → First de-interleaver → First FEC decoder

FIG. 2E

Transmitter device: First interleaver → Second interleaver → First FEC encoder → Second FEC encoder → Channel

Receiver device: Second FEC decoder → First FEC decoder → Second de-interleaver → First de-interleaver

First FEC encoder → Data location transformer → Second FEC encoder

Transmitter device

Channel

Second FEC decoder → Data location inverse transformer → First FEC decoder

Receiver device

FIG. 2F

First FEC encoder → Second FEC encoder → Data location transformer

Transmitter device

Channel

Data location inverse transformer → Second FEC decoder → First FEC decoder

Receiver device

FIG. 2G

```
┌─────────────────────────────────────────────────────────┐        ┌─────────────────────────────────────────────────────────┐
│ ┌─────────┐   ┌───────────┐   ┌─────────┐   ┌─────────┐  │Channel │ ┌───────────┐  ┌─────────┐  ┌───────────┐  ┌─────────┐  │
│ │ First   │   │ Data      │   │ Second  │   │ First   │  │        │ │ First de- │  │ Second  │  │ Data      │  │ First   │  │
│ │ FEC     │──▶│ location  │──▶│ FEC     │──▶│interleaver──────────▶│interleaver│─▶│ FEC     │─▶│ location  │─▶│ FEC     │  │
│ │ encoder │   │transformer│   │ encoder │   │         │  │        │ │           │  │ decoder │  │ inverse   │  │ decoder │  │
│ └─────────┘   └───────────┘   └─────────┘   └─────────┘  │        │ └───────────┘  └─────────┘  │transformer│  └─────────┘  │
│                                                          │        │                             └───────────┘               │
│                   Transmitter device                     │        │                 Receiver device                          │
└─────────────────────────────────────────────────────────┘        └─────────────────────────────────────────────────────────┘
```

FIG. 2H

FIG. 2I

FIG. 2J

FIG. 2K

FIG. 2L

Transmitter device: First FEC encoder → First interleaver → Data location transformer → Second FEC encoder → Second interleaver

Channel

Receiver device: Second de-interleaver → Second FEC decoder → Data location inverse transformer → First de-interleaver → First FEC decoder

FIG. 2M

FIG. 2N

Obtain transmission information of a first data stream — S10

If the transmission information meets a trigger condition, adjust an error correction capability of a receiver apparatus — S20

FIG. 3

Apparatus for processing an Ethernet data stream

Obtaining module — 401

Adjustment module — 402

FIG. 4

Apparatus for processing an Ethernet data stream

Configuration module

FIG. 5

FIG. 6

FIG. 7

## INTERNATIONAL SEARCH REPORT

| International application No. |
|---|
| **PCT/CN2024/085098** |

**A. CLASSIFICATION OF SUBJECT MATTER**

H04L 1/00(2006.01)i

According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT: CNKI; ENTXTC; VEN; ENTXT; IEEE: 前向纠错, 比特误码率, 纠正, 纠错, 交织, 解交织, 调整, 去使能, 减弱, FEC, error-correction, de-interleav???, interleav???, reduce, disable, adjust+

**C. DOCUMENTS CONSIDERED TO BE RELEVANT**

| Category* | Citation of document, with indication, where appropriate, of the relevant passages | Relevant to claim No. |
|---|---|---|
| X | CN 101841389 A (ADAPTIVE SPECTRUM & SIGNAL) 22 September 2010 (2010-09-22) description, paragraphs [0003]-[0115] | 1-59 |
| A | US 2003009719 A1 (MATSUSHITA ELECTRIC INDUSTRIAL CO., LTD.) 09 January 2003 (2003-01-09) entire document | 1-59 |
| A | US 2011113294 A1 (TRELLISWARE TECHNOLOGIES INC.) 12 May 2011 (2011-05-12) entire document | 1-59 |
| A | US 2014112376 A1 (BROADCOM CORP.) 24 April 2014 (2014-04-24) entire document | 1-59 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 June 2024** | **29 June 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/085098**

| Patent document cited in search report | | | Publication date (day/month/year) | Patent family member(s) | | | Publication date (day/month/year) |
|---|---|---|---|---|---|---|---|
| CN | 101841389 | A | 22 September 2010 | None | | | |
| US | 2003009719 | A1 | 09 January 2003 | US | 6988233 | B2 | 17 January 2006 |
| US | 2011113294 | A1 | 12 May 2011 | US | 8335949 | B2 | 18 December 2012 |
| US | 2014112376 | A1 | 24 April 2014 | US | 8873659 | B2 | 28 October 2014 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 202310377636